(19) Europäisches Patentamt
European Patent Office
Office européen des brevets

(11) **EP 2 650 730 A2**

(12) **EUROPÄISCHE PATENTANMELDUNG**

(43) Veröffentlichungstag:
**16.10.2013 Patentblatt 2013/42**

(51) Int Cl.:
***G03F 7/20*** (2006.01)   ***G02B 7/02*** (2006.01)
***G02B 27/00*** (2006.01)

(21) Anmeldenummer: **13175621.5**

(22) Anmeldetag: **21.09.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **21.09.2006   DE 102006045075**

(62) Dokumentnummer(n) der früheren Anmeldung(en) nach Art. 76 EPÜ:
**07818354.8 / 2 064 595**

(71) Anmelder: **Carl Zeiss SMT GmbH**
**73447 Oberkochen (DE)**

(72) Erfinder:
  • **Eva, Eric**
    **73434 Aalen (DE)**
  • **Tayebati, Payam**
    **64560 Riedstadt (DE)**
  • **Thier, Michael**
    **73563 Moegglingen (DE)**
  • **Hauf, Markus**
    **89075 Ulm (DE)**
  • **Schoenhoff, Ulrich**
    **89073 Ulm (DE)**

  • **Fluegge, Ole**
    **73566 Barholomae (DE)**
  • **Kazi, Arif**
    **73430 Aalen (DE)**
  • **Sauerhoefer, Alexander**
    **27765 Hamburg (DE)**
  • **Focht, Gerhard**
    **57234 Wilmsdorf (DE)**
  • **Weber, Jochen**
    **89520 Grosskuchen (DE)**
  • **Gruner, Toralf**
    **73433 Aalen (DE)**

(74) Vertreter: **Raunecker, Klaus Peter**
**Lorenz & Kollegen**
**Patentanwälte Partnerschaftsgesellschaft**
**Alte Ulmer Straße 2**
**89522 Heidenheim (DE)**

Bemerkungen:
Diese Anmeldung ist am 08-07-2013 als Teilanmeldung zu der unter INID-Code 62 erwähnten Anmeldung eingereicht worden.

(54) **Optisches Element und Verfahren**

(57)   Die Erfindung betrifft ein optisches Element (1) zur zumindest teilweisen, ortsaufgelösten Korrektur eines Wellenfrontfehlers eines mit einer optischen Strahlung beaufschlagbaren optischen Systems, beinhaltend einen für die optische Strahlung optisch wirksamen Bereich und elektrische Leiterbahnen (3) in diesem optisch wirksamen Bereich, wobei die elektrischen Leiterbahnen mindestens abschnittsweise lateral zur Einfallsrichtung der optischen Strahlung einen Durchmesser von höchstens 50 Mikrometer haben.

**FIG.100**

Printed by Jouve, 75001 PARIS (FR)

**Beschreibung**

Die vorliegende Erfindung betrifft ein optisches Element und ein Verfahren zur Beeinflussung des optischen Verhaltens dieses optischen Elements, sowie die Verwendung des optischen Elements in einem optischen System, vorzugsweise in einer Projektionsbelichtungsanlage für die Mikrolithographie. Ferner betrifft die vorliegende Erfindung eine Projektionsbelichtungsanlage bzw, ein Projektionsobjektiv für die Mikrolithographie, welche bzw. welches das erfindungsgemäße optische Element enthält. Ferner betrifft die vorliegende Erfindung ein Verfahren zum Betrieb dieser erfindungsgemäßen Projektionsbelichtungsanlage bzw. dieses erfindungsgemäßen Projektionsobjektivs.

In modernen Projektionsobjektiven für die Mikrolithographie wird eine Vielzahl von Wellenfront-Manipulatoren zur Korrektur von optischen Aberrationen eingesetzt. Die meisten dieser Manipulatoren bewirken eine Wellenfront-Korrektur über mechanische Manipulation von optischen Elementen. Dies geschieht entweder über eine Positionsänderung und/oder über eine Deformation der optischen Elemente. Diese Manipulatoren haben Korrekturmöglichkeiten für niederwellige Wellenfrontfehler wie sie typischerweise bei der Verwendung der Objektive in Verbindung mit sogenannten konventionellen Settings und bei einem Durchsatz von etwa 120 Wafer/ Stunde auftreten.

Stetig steigende Durchsatz-Anforderungen bedingen jedoch immer höhere Lichtintensitäten im Objektiv und damit eine stetig steigende Thermallast, die auf die optischen Elemente wirkt. Diese Thermallast verursacht Wellenfront-Fehler: bei Linsen über den temperaturabhängigen Brechungsindex und die Oberflächendeformation, bei Spiegeln vorwiegend durch die Oberflächendeformation aufgrund der thermischen Ausdehnung des Spiegelsubstrates. Hinzu kommt in der Entwicklung der Lithographie der Trend zu Beleuchtungs-Settings, wie zum Beispiel den Dipol-Settings, die eine starke Fokussierung der Lichtleistungsdichte auf insbesondere pupillennahen Linsen mit sich bringen und damit, aufgrund der hieraus resultierenden lokal hohen Thermallast, auch radiale und/oder azimutale höherwellige und stark lokalisierte Wellenfrontfehler verursachen können. Diese können mit den eingangs erwähnten Manipulatoren nur noch bedingt kompensiert werden. Das gleiche gilt für Wellenfrontfehler, die durch lichtinduzierte Lebensdauereffekte wie Compaction, welche aufgrund der höheren optischen Leistungsdichten verstärkt hervortritt, verursacht werden. Auch diese Wellenfrontfehler können mit den bisher bekannten Manipulatoren nicht effizient kompensiert werden.

Eine Möglichkeit, diese durch Lebensdauereffekte verursachten Wellenfrontfehler in effizienterer Weise zu kompensieren, ist derzeit die Verwendung von tauschbaren Platten, auf die spezielle Korrekturasphären aufgebracht sind. Innerhalb der Lebensdauer des Objektivs müssen diese Kompensationsplatten mehrmals getauscht werden, um den Änderungen der Wellenfrontfehler während der Lebensdauer des Objektivs angemessen gerecht zu werden.

Kompensationsplatten mit Korrekturasphären können zwar Fehler kompensieren, sie sind aber zur Kompensation dynamisch schnell veränderlicher Fehler eher ungeeignet. Auch muss der zu kompensierende Fehler vor der Erstellung der Kompensationsplatte und insbesondere damit vor ihrem Einbau in das Projektionsobjektiv bekannt sein. Da mit dem Einbau der Kompensationsplatte wiederum neue Wellenfrontfehler induziert werden, ist hier naturgemäß keine vollständige Kompensation möglich.

Die zu lösende Problemstellung besteht nun darin, einen Wellenfront-Manipulator zu finden, mit dem möglichst flexibel Wellenfrontfehler, synonym Aberrationen, und hierbei insbesondere radial und/oder azimutal höherwellige Aberrationen, kompensiert werden können. Eine ideale Lösung dieses Problems besteht aus steuerbaren, 2-dimensionalen Korrekturasphären, welche insbesondere die radial und/oder azimutal höherwellige Aberrationen kompensieren.

Wie bereits erwähnt sind etablierte Manipulatoren im obigen Sinne insbesondere mechanischer Art. So beschreibt beispielsweise die DE 198 24 030 A1 ein katadioptrisches Projektionsobjektiv mit adaptiven Spiegeln, wobei Spiegel mit Stellelementen derart verformbar sind, dass bestimmte Bildfehler reduziert werden.

Aus EP 678 768 und DE 198 59 634 A1 sind Projektionsbelichtungsanlagen bekannt, bei denen Linsen oder Spiegel mittels Aktuatoren zur Bildfehlerkorrektur ebenfalls verformt werden.

Da mechanische Elemente im optischen Strahlengang jedoch Abschattung und Streulicht verursachen, sind, im Falle von zu manipulierenden Linsen, mechanische Konzepte auf die Manipulation des Linsenrandes beschränkt. Diese Beschränkung auf den Linsenrand stellt eine inhärente Einschränkung der möglichen Korrekturprofile und speziell der radialen Ordnungen dar, die sich auch durch aufwendige Mechanismen nicht umgehen lässt.

Alternativ zu den mechanischen Manipulatoren sind thermische Manipulatoren bekannt, wobei die thermischen Manipulatoren ebenfalls am Linsenrand angeordnet sind wie beispielsweise in der US-Patentschrift US 6,198,579 B1. Die in der genannten Schrift vorgeschlagenen thermischen Manipulatoren zeigen jedoch die gleichen Begrenzungen in den radialen Ordnungen wie ihre mechanischen Pendants und implizieren zusätzlich relativ lange Zeitkonstanten, die durch die Ausbreitungsgeschwindigkeit der Wärme über den Linsendurchmesser gegeben sind. Randaktuierte thermische Manipulatoren eignen sich deshalb vorwiegend zu Kompensation von zeitlich stationären Wellenfront-Fehlern. Aufgrund der langen Zeitkonstanten eignen sich solche Manipulatoren jedoch nur sehr bedingt für die Kompensation von transienten Wellenfrontfehlern.

Ferner ist ein Verfahren zur Korrektur nicht rotationssymmetrischer Bildfehler mit am Umfang von Linsen angeordneten Peltier-Elementen aus der DE 198 27 602 A1 bekannt, wobei die Peltier-Elemente das Temperaturverhalten des optischen Elements derart beeinflussen, dass bei nicht rotationssymmetrischer Durchstrahlung des Elements daraus resultierende Abbildungsfehler korrigierbar sind.

Eine Vorrichtung und ein Verfahren zur Korrektur asymmetrischer Temperaturbelastungen eines optischen Elements wie einer Linse oder eines Spiegels sind ebenfalls aus der DE 198 59 634 A1 bekannt, bei der das optische Element ebenfalls mittels Aktuatoren deformiert wird.

Aus der WO 2004/036316 ist ein Korrekturverfahren von Abbildungsfehlern optischer Elemente wie Spiegeln und Linsen bekannt, bei dem mittels zusätzlicher Einstrahlung die Temperatur der optischen Elemente derartig verändert wird, dass die Abbildungs- fehler reduziert werden. Aus der US 6 081 388 ist bekannt, , Oberflächen von Linsen mittels Aktuatoren oder definierten mechanischen Kräften derart zu verformen, dass eine Beeinflussung der Abbildungsfehler erfolgt.

Ferner ist aus der US 6 521 877 B1 bekannt, die Temperatur eines optischen Elementes lokal über transparente Widerstandsschichten zu beeinflussen; eine alternative Lösung ist in der US 6 466 382 B2 offenbart, wo vorgeschlagen wird, auf einer Linse Schichten mit absorbierenden Eigenschaften aufzubringen, die eine zu dem Footprint des Nutzlichtes komplementäre Struktur haben.

Die Schriften US2007/0019305 A1, US2003/0021040 A1, WO2006/128613 A1, JP2004/246343 A1, EP0678768 A2, US6198579B1 sowie DE 10 2005 062401 A1 zeigen weitere Konzepte zur Verbesserung der Abbildungseigenschaften optischer Systeme wie bspw. Projektionsobjektive für die Halbleiterlithographie.

Die Aufgabe der vorliegenden Erfindung ist es, ein alternatives Verfahren zur Korrektur von Projektionsbelichtungsanlagen für die Mikrolithographie hinsichtlich ihrer Abbildungsfehler bereitzustellen, wobei insbesondere zeitlich veränderliche Abbildungsfehler und / oder azimutal und / oder radial höherwellige Abbildungsfehler als relevant erachtet sind. Eine weitere Aufgabe der vorliegenden Erfindung ist es, ein optisches Element sowie ein Verfahren anzugeben, das es erlaubt, eine auf das optische Element einfallende elektromagnetische Strahlung zeitlich und räumlich lokal zu beeinflussen. Ferner ist eine Aufgabe der vorliegenden Erfindung, eine Projektionsbelichtungsanlage bzw. ein Projektionsobjektiv für die Halbleiterlithographie anzugeben, welche bzw. welches hinsichtlich etwaiger Abbildungsfehler dynamisch korrigiert werden kann.

Ferner ist es die Aufgabe der Erfindung, ein Verfahren zum Betrieb einer Projektionsbelichtungsanlage bzw. eines Projektionsobjektivs für die Halbleiterlithographie anzugeben, welche eine örtlich und zeitlich stark aufgelöste Korrektur von Abbildungs- fehlern erlaubt.

Diese Aufgabe wird durch die Vorrichtungen mit den in den unabhängigen Ansprüchen aufgeführten Merkmalen gelöst. Die Unteransprüche betreffen vorteilhafte Varianten und Weiterbildungen der Erfindung.

Eine Lösung der obigen Problemstellung besteht nun darin, ein optisches Element mit einem frei einstellbaren Temperaturprofil zu realisieren. Notwendig hierzu ist die Fähigkeit, dem Element an jeder Stelle Wärme zuzuführen zu können. Die Anforderungen an die optische Performance der Projektionsobjektive bedingen jedoch sehr stringente Einschränkungen hinsichtlich der optisch wirksamen Elemente, die im Strahlengang platziert werden dürfen. Für pupillennahe Elemente ergibt sich eine maximale erlaubte homogene Flächendeckung, d.h. eine Abschattung des Stahlenganges, von grössenordnungsmässig wenigen Promille. Für feldnahe Elemente sind die Einschränkungen noch stärker. Die Verwendung von fluid-mechanischen Wärmepumpen ist damit ausgeschlossen.

Das erfindungsgemäße optische Element besitzt wenigstens eine elektrische Leiterbahn, wobei die optische Wirkung des optischen Elementes durch eine Ansteuerung der Leiterbahn beeinflussbar ist.

Die optische Dicke des optischen Elements kann somit über die Temperaturabhängigkeit des optischen Brechungsindexes des optischen Elementes variiert werden. Die Phasenvariation $\Delta\varphi$ ist dabei näherungsweise proportional zum durchlaufenen erwärmten Weg im optischen Element $\Delta Z$, der Temperatursensitivität des optischen Brechungsindexes dn/dT und der Temperaturvariation $\Delta T$

$$\Delta\varphi \approx \Delta Z \frac{dn}{dT}\Delta T$$

Für eine gegebene Geometrie des optischen Elementes ist die Phasenänderung somit näherungsweise proportional zur Temperaturänderung. Eine optische Wellenfront, die ein optisches Element durchläuft, erfährt daher eine Wellenfrontdeformation, die dem Temperaturprofil des optischen Elementes entspricht. Umgekehrt kann eine deformierte Wellenfront durch ein geeignetes inverses Temperaturprofil korrigiert werden.

Innerhalb des sehr kleinen Temperaturbereichs von typischerweise weniger als einem Kelvin bis zu einigen Kelvin kann die Temperaturänderung des Brechungsindexes als konstant über die Temperatur angenommen werden. Für Quarzglas ergibt sich zum Beispiel eine Empfindlichkeit von etwa 0.002/1mK, mit 1K Temperaturhub kann also bei 20mm Glasdicke ein Phaseneffekt von 400nm erzeugt werden.

Dies ist hinreichend zur Korrektur der typischen Amplituden von hochwelligen Wellenfrontfehlern in Projektionsobjektiven für die Mikrolithographie.

Zusätzlich zur Brechzahländerung wird auch die wärmebedingte Ausdehnung des optischen Elementes für die Veränderung der optischen Wirkung des optischen Elementes relevant. Diese Phasenvariation $\Delta\varphi$ ist dabei örtlich lokal näherungsweise proportional zum Sprung des Brechungsindex an der Grenze des optischen Elementes $\Delta n$, der Ausdehungssensitivität bzw. des thermischen Ausdehnungskoeffizienten (CTE) des optischen Elementes $dZ/dT$ und der Temperaturvariation $\Delta T$

$$\Delta\varphi \approx \Delta n \frac{dZ}{dT} \Delta T$$

Je nach Anordnung der Leiterbahn im optischen Element variieren dabei die Anteile der Wirkungen aus der Änderung des Brechungsindexes des optischen Elementes und der Formvariation einer optisch wirksamen Fläche des optischen Elementes, Bei Spiegeln ist naturgemäß nur Letzteres wirksam.

Wird eine Leiterbahn zur Temperierung verwendet, so ist es aufgrund der bereits geschilderten Abschattungsproblematik einerseits vorteilhaft, wenn diese mindestens abschnittsweise orthogonal zur Einfallsrichtung der optischen Strahlung einen Querschnitt von weniger als $50\,\mu m$ aufweist, damit die Leiterbahn an sich die optische Wirkung des optischen Elementes nicht beeinträchtigt. Andererseits ist es vorteilhaft, durch eine hinreichende Dichte der Leiterbahnen die örtlich freie Einstellbarkeit der Temperatur im optischen Element zu gewährleisten. Vorteilhaft sind Abstände zwischen den Leiterbahnen, die eine laterale Auflösung des Wellenfrontfehlers von 10 - 15 Prozent des Pupillendurchmessers gewährleisten.

In Abhängigkeit von der Position des erfindungsgemäßen optischen Elementes in dem abbildenden System, in dem es zum Einsatz kommt, können auch kleinere Ausdehnungen der Leiterbahn als $50\,\mu m$ von Vorteil sein. Bei einer Position im Bereich einer Pupillenebene eines Projektionsobjektives für die Halbleiterlithographie sind insbesondere Ausdehnungen von ca. $1\,\mu m$ äußerst vorteilhaft. Diese zusätzlich einschränkende Maßnahme hat die Wirkung, dass aufgrund des vergleichsweise geringen Durchmessers der Leiterbahn eine Beeinträchtigung der Funktionalität des optischen Elementes weitgehend vermieden oder sogar ausgeschlossen wird, und dass bei einer geeigneten räumlichen Verteilung der Leiterbahn nur ein geringer Anteil des optisch wirksamen Anteils des optischen Elementes von der Abschattung betroffen ist.

Mit Methoden der Feinstleiterätzung aus der Leiterplattenherstellung, der Lithographie, der Elektronenstrahl Lithographie oder mit Laser-Mikrostrukturierung ist es möglich, die Leiterbahnen bis zu einer minimalen Ausdehnung von ca. $0.5\,\mu m$ bis zu 10 nm herzustellen.

Um einen negativen Einfluss der Leiterbahnen an sich auf die optische Wirkung des optischen Elementes zu vermeiden ist nicht nur der Durchmesser der Leiterbahnen zu beschränken sondern auch die von den Leiterbahnen insgesamt verursachte Abschattung im optischen Element.

Im Fall der Anwendung der Erfindung für in einem Projektionsobjektiv für die Halbleiterlithographie verwendete optische Elemente lässt sich die folgende Abschätzung vornehmen: abhängig von der Position des optischen Elementes im Objektiv seien beispielsweise Blasenklassen bis 5x0,25 erlaubt. Dies entspricht einer Gesamtfläche von $1.25\,mm^2$. Nach ISO 1010-3 ist es erlaubt, diese Fläche auf mehr Blasen einer äquivalenten Gesamtfläche zu verteilen, solange hierbei keine Häufung auftritt. In erster Näherung wäre es also zulässig, eine Leiterbahn mit einer Länge von bis zu 1,25m und einer Breite von $1\,\mu m$ auf dem optischen Element zu verteilen. Gegebenenfalls kann durch Unregelmäßigkeiten in der Verteilung oder der Breite und der Querschnittsform der Leiterbahn sichergestellt werden, dass es nicht zu systematischen Effekten wie z. B. der Beeinflussung bestimmter Beugungsordnungen oder einem gerichtetem Streulicht kommt.

Die Erfindung eignet sich insbesondere für eine Anwendung im durchstrahlten Bereich von Linsen oder Planplatten; ebenso ist aber auch eine Verwendung auf oder auch hinter der reflektiven Oberfläche eines Spiegels denkbar. Ebenso ist eine Verwendung in Strahlteilern denkbar, welches aus einem refraktiven und einem reflektiven Teil bestehen. Die durch den Wärmeeintrag induzierte optische Wirkung entspricht in allen Fällen, wo ein erster, von Licht durchtretender und ein zweiter, das Licht reflektierender Bereich des optischen Elementes auftritt, der Überlagerung der oben beschriebenen Wirkungen auf den Brechungsindex und die Formvariation des optischen Elementes.

Durch die wenigstens eine vorzugsweise verteilt angeordnete elektrisch leitende Leiterbahn im Bereich einer optisch wirksamen optischen Fläche des erfindungsgemäßen optischen Elements lässt sich vorteilhaft über elektrische Leistung das optische Element in der Nähe der optisch wirksamen Fläche lokal erwärmen, z.B. um einige Millikelvin, so dass sich die optisch wirksame Fläche aufgrund des Wärmeeintrags hinsichtlich ihrer Form oder anderer Parameter steuerbar verändern lässt, Damit ist es möglich, die optische Wirkung des optischen Elements mittels der durch die elektrisch leitende Leiterbahn eingetragenen elektrischen Leistung zu steuern. Dies lässt sich dazu verwenden, um in einem optischen Abbildungssystem, wie z. B. einer Projektionsbelichtungsanlage, Abbildungsfehler höherer Ordnung dynamisch zu korrigieren. Durch den möglichen Einsatz des Korrekturelementes in Transmission lassen sich Abbildungsfehler höherer radialer und / oder azimutaler Ordnung an beliebigen Positionen in einem optischen Abbildungssystem korrigieren, also insbesondere auch an Positionen, an denen keine lokal deformierbaren Spiegel vorgesehen sind, beispielsweise also auch in rein refraktiven optischen Abbildungssystemen.

Der Wellenlängenbereich der auf das optische Element einfallenden, elektromagnetischen Strahlung liegt vorzugsweise im optischen Bereich bis hin zum extrem ultravioletten Bereich (EUV), das heißt, in einem Spektralbereich von ca. 10 nm - ca. 1 $\mu$m. Das optische Element der vorliegenden Erfindung lässt sich jedoch auch anwenden für elektromagnetische Strahlung, die den wellenlängenbereich von 1 $\mu$m übersteigt wie z. B. im Infrarot- und Ferninfrarotbereich bis hin zu 10 $\mu$m.

Die wenigstens eine im optischen Element vorzugsweise verteilt angeordnete, elektrisch leitende Leiterbahn kann sowohl auf einer optisch wirksamen Fläche des optischen Elementes als auch unterhalb einer optisch wirksamen Oberfläche im Inneren des optischen Elementes angeordnet sein. Die elektrisch leitende Leiterbahn des erfindungsgemäßen optischen Elements umfasst ferner Anschlusselemente zum elektrischen Ansteuern der Leiterbahn.

Das erfindungsgemäße optische Element gestattet es, die Wellenfront der elektromagnetischen Strahlung mit einer ähnlichen Ortsauflösung wie bei der Verwendung von mittels Ion Beam Figuring hergestellte Korrekturasphären zu kontrollieren, allerdings kann die Einstellung im Unterschied zu der konventionellen Vorgehensweise dynamisch innerhalb weniger Sekunden geändert werden.

Durch die Verwendung vorab berechneter, statischer Heizprofile kann die aufwendige Herstellung und Integration der o. g. Korrekturasphären ersetzt werden. Ebenso können verschiedene, vorprogrammierte Korrekturwirkungen dynamisch "aufgeschaltet" werden, was zur Verbesserung der Auflösung bei bestimmten Anwendungen dienen kann. Vorausberechnete, oder von Messdaten abgeleitete Korrekturprofile können dabei Abbildungsfehler aufgrund von Compaction/Rarefaction (d. h. lokale Dichteänderungen des Materials des optischen Elementes), verspannten Fassungen der optischen Elemente oder oberflächendeformationen des optischen Elementes korrigieren. Im Zusammenspiel mit Informationen aus einem Steuerrechner über den aktuellen Betriebsmodus des Systems, in dem das erfindungsgemäße optische Element eingesetzt ist, können dynamisch lokale Dichte- und Formänderungen aufgrund der Erwärmung des optischen Elementes kompensiert werden. Ferner ist auch eine automatische Rückkopplungsschleife denkbar, bei der Daten von Wellenfrontsensoren direkt zur Ableitung des benötigten Heizprofils verwendet werden.

In einer bevorzugten Ausführungsform weist das optische Element eine wenigstens teilweise transparente und/oder reflektive wirksame optische Fläche auf. Dabei kann das optische Element als Strahlteilerwürfel, Strahlteilerplatte, planparallele Platte, Keilplatte oder allgemein als refraktives optisches Element (RO-E) ausgebildet sein. Vorzugsweise ist das erfindungsgemäße optische Element als Linse z. B. als Sammellinse, Zerstreuungslinse, Fresnellinse oder fresnelsche Zonenplatte ausgebildet.

Das erfindungsgemäße optische Element kann auch ein mindestens teilweise spiegelndes Element sein, bspw. eine Strahlteilervorrichtung. Bei solchen optischen Elementen kann die verspiegelte Fläche auf der Eingangsseite des optischen Elementes für den Nutzlichstrahlengang oder auf dessen Ausgangsseite angeordnet sein. Entsprechend wirkt sich die Erwärmung des optischen Elementes auf die oberflächenform der Eingangsseite bzw., im anderen Fall, auf die Oberflächenform der Ausgangsseite sowie auf den Brechungsindex des optischen Elementes aus. Ferner lässt sich das erfindungsgemäße optische Element als diffraktives optisches Element realisieren wie z. B. in Form eines Reflexions- bzw. Transmissionsgitters. Weiter lässt sich das erfindungsgemäße optische Element auch als kombiniertes Element aus brechenden, reflektierenden und/ oder beugenden Strukturen realisieren.

Die wenigstens eine Leiterbahn des erfindungsgemäßen optischen Elements kann mindestens abschnittsweise einen Durchmesser bzw. eine Querschnittsdimension von weniger als 50 $\mu$m aufweisen, vorzugsweise liegt der Durchmesser bzw. die Querschnittsdimension zwischen 50 nm und 1 $\mu$m.

Figur 100     eine Illustration des grundlegenden Prinzips der Erfindung;

Figur 101     eine Illustration der Einflüsse des Wärmeeintrages auf ein optisches Element;

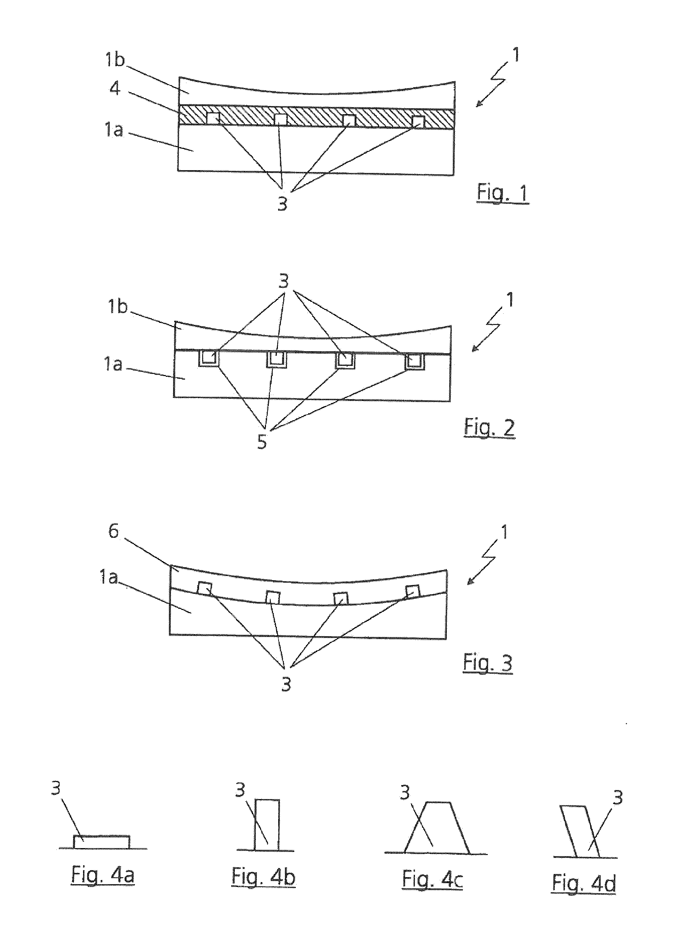

Figur 1     ein zweiteilig aufgebautes optisches Element;

Figur 2     eine erste Variante der Erfindung;

Figur 3     eine Ausführungsform der Erfindung, bei der die Leiterbahnen auf die fertig polierte Oberfläche eines Substrats aufgebracht sind;

Figur 4     verschiedene Varianten des Querschnittprofils der Leiterbahnen;

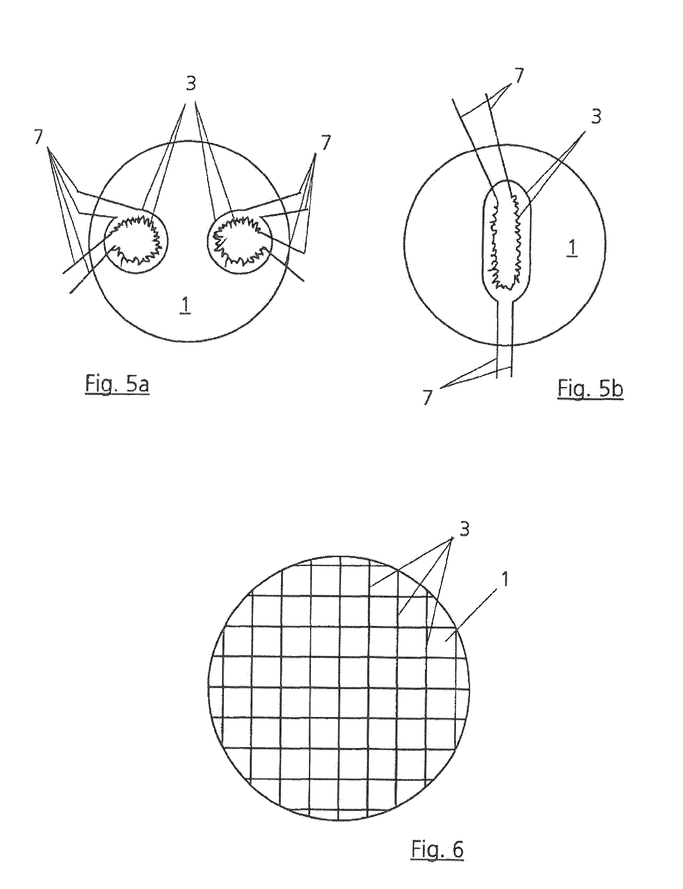

Figur 5     in den Teilfiguren 5a und 5b Ausführungsformen der Erfindung, bei denen Gebiete großer Wärmeleistungsdichten nachgebildet werden;

Figur 6     die Anordnung von Leiterbahnen in einer Matrixstruktur;

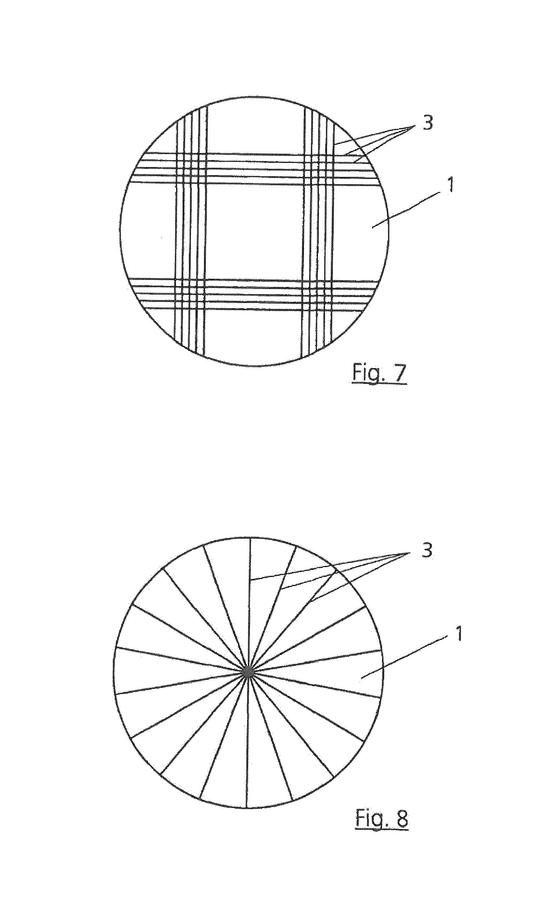

Figur 7     eine Matrixstruktur mit nicht äquidistanten Leiterbahnen;

Figur 8     eine sternförmige Anordnung der Leiterbahnen;

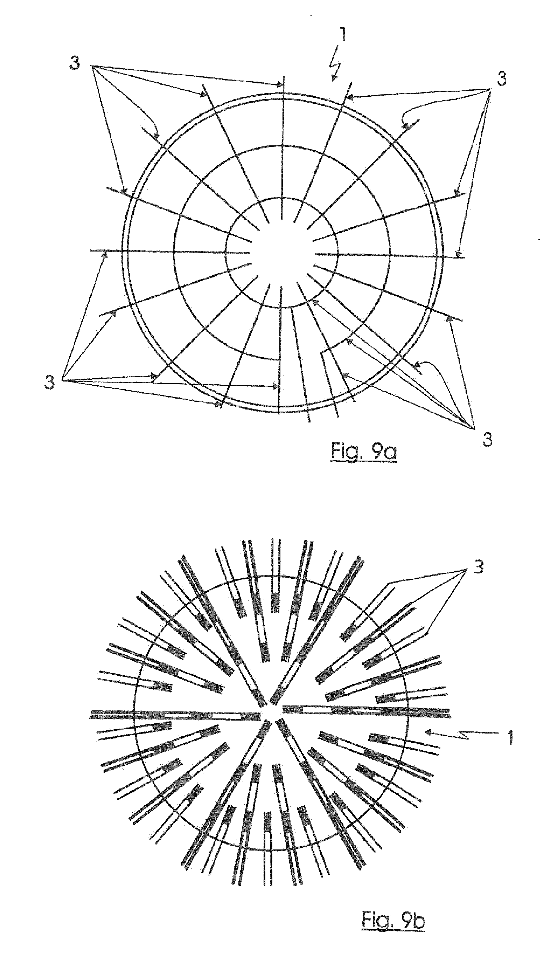

Figur 9 in den Teilfiguren 9a und 9b rotationssymmetrische Anordnungen der Leiterbahnen;

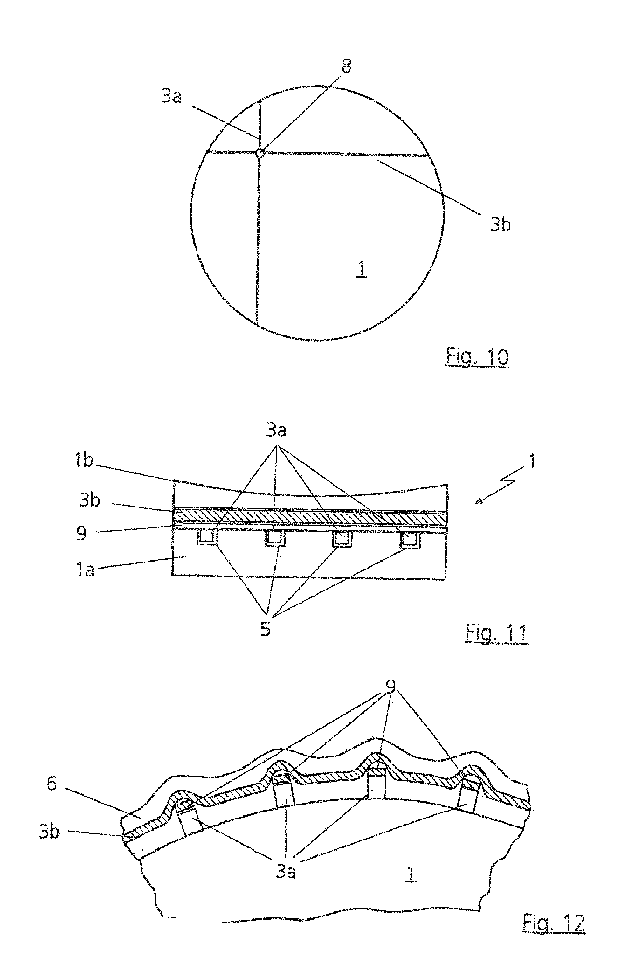

Figur 10 eine Variante der Erfindung, bei der die Leiterbahnen in ihren Kreuzungspunkten über Widerstände verbunden sind;

Figur 11 eine Abwandlung der in Figur 10 dargestellten Ausführungsform;

Figur 12 eine weitere Abwandlung der in Figur 10 gezeigten Ausführungsform;

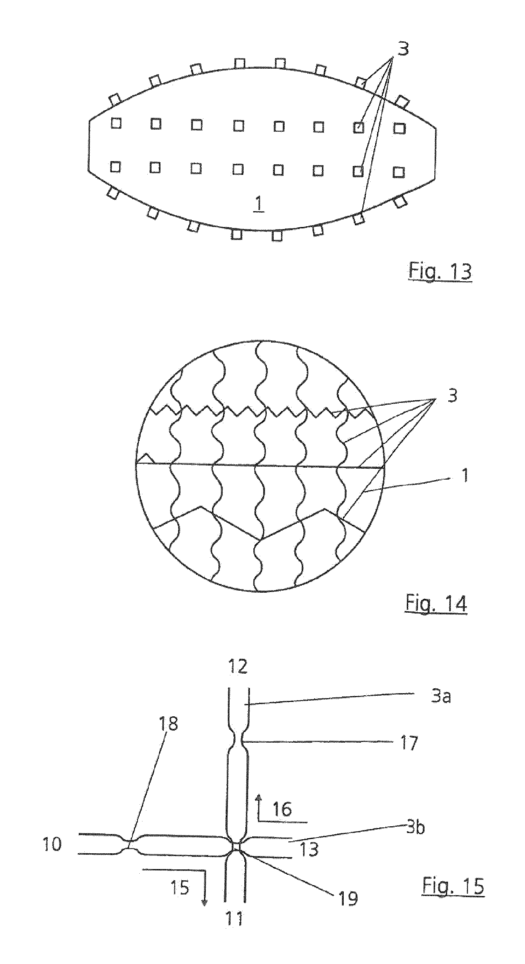

Figur 13 eine Möglichkeit, Leiterbahnen auf beiden Seiten des optischen Elements anzuordnen;

Figur 14 verschiedene unregelmäßige Matrixstrukturen;

Figur 15 eine weitere Variante der Erfindung;

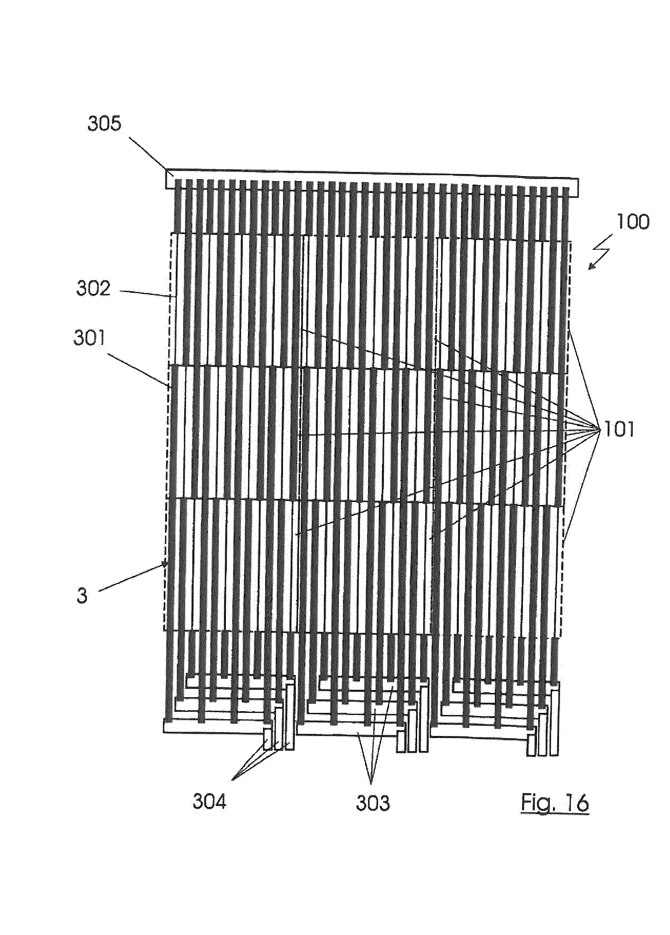

Figur 16 eine Möglichkeit zur räumlich hoch aufgelösten thermischen Ansteuerung verschiedener Oberflächenbereiche eines optischen Elementes;

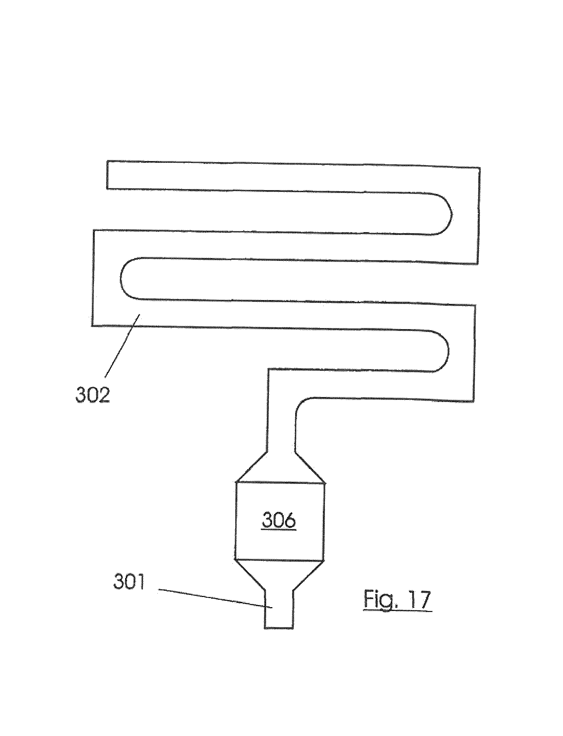

Figur 17 eine vorteilhafte Ausführungsform des Zuleitungsdrahtes, eines mäanderförmigen Heizdrahtes und des Übergangsbereiches;

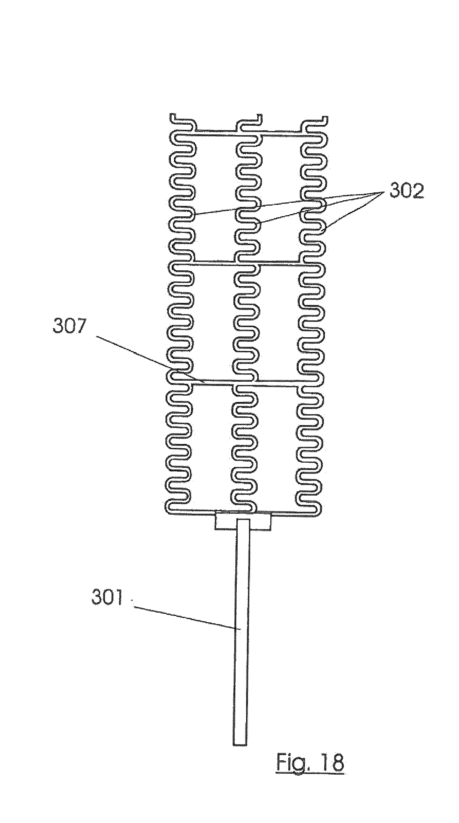

Figur 18 eine Möglichkeit, die Heizdrähte so anzuordnen, dass diese robust gegenüber lokalen Defekten sind;

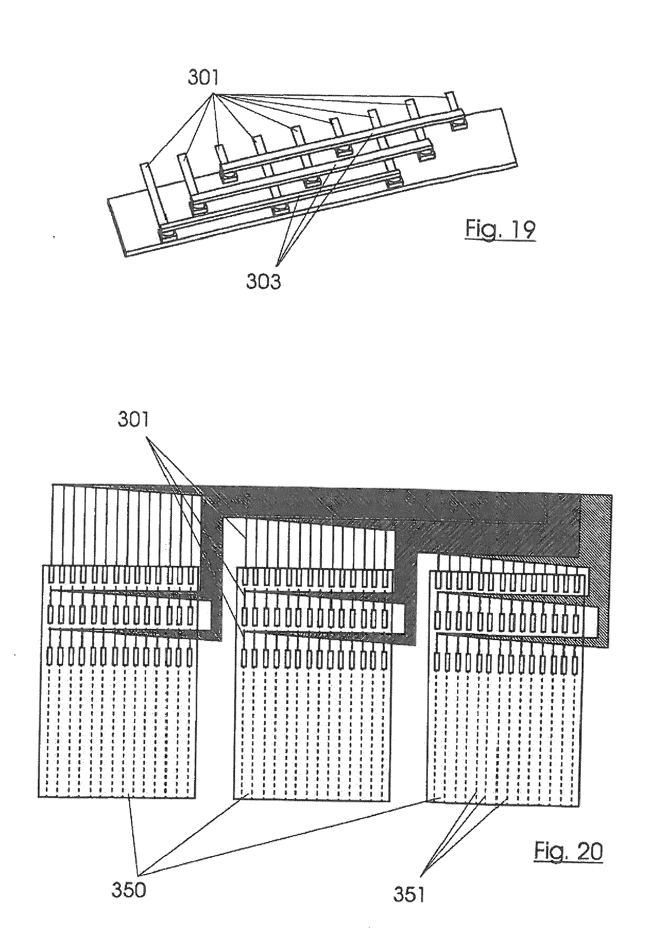

Figur 19 eine dreidimensionale prinzipielle Darstellung der Gruppierung der Leiterbahnen;

Figur 20 eine Kontaktierung und Gruppierung über flexible Leiterfolien zur elektrischen Anbindung;

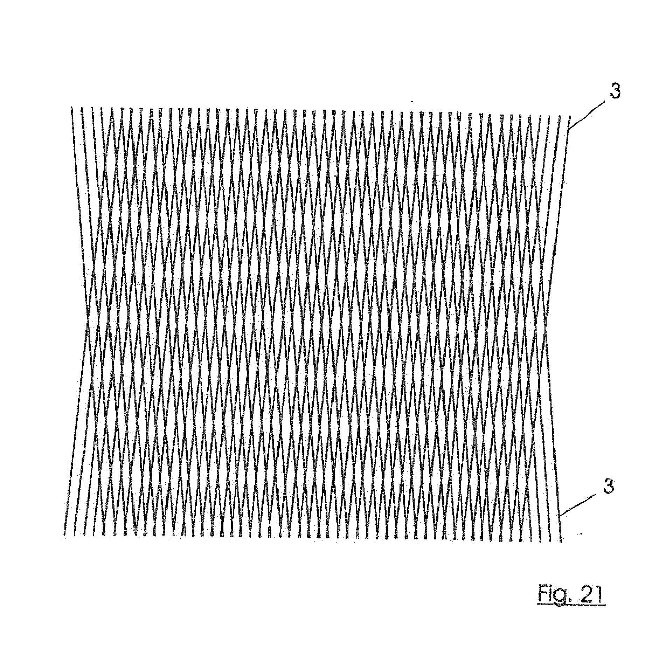

Figur 21 eine Möglichkeit, bei zwei übereinander liegenden plattenförmigen erfindungsgemäßen optischen Elementen Moire-Effekte zu vermeiden und gleichzeitig von der Vorzugsrichtung hinsichtlich Streulicht zu profitieren;

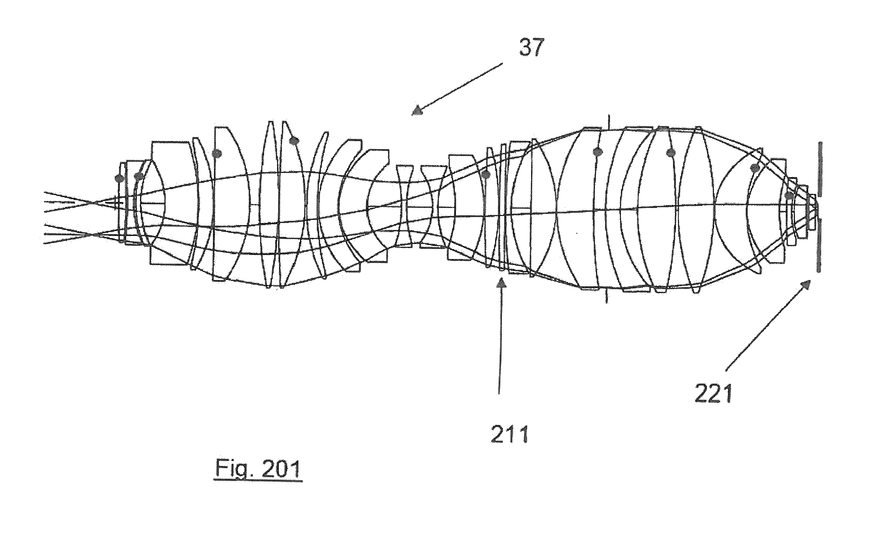

Figur 201 ein erfindungsgemäßes Projektionsobjektiv für die Mikrolithographie mit einem erfindungsgemäßen optischen Element und einer erfindungsgemäßen Streulichtblende;

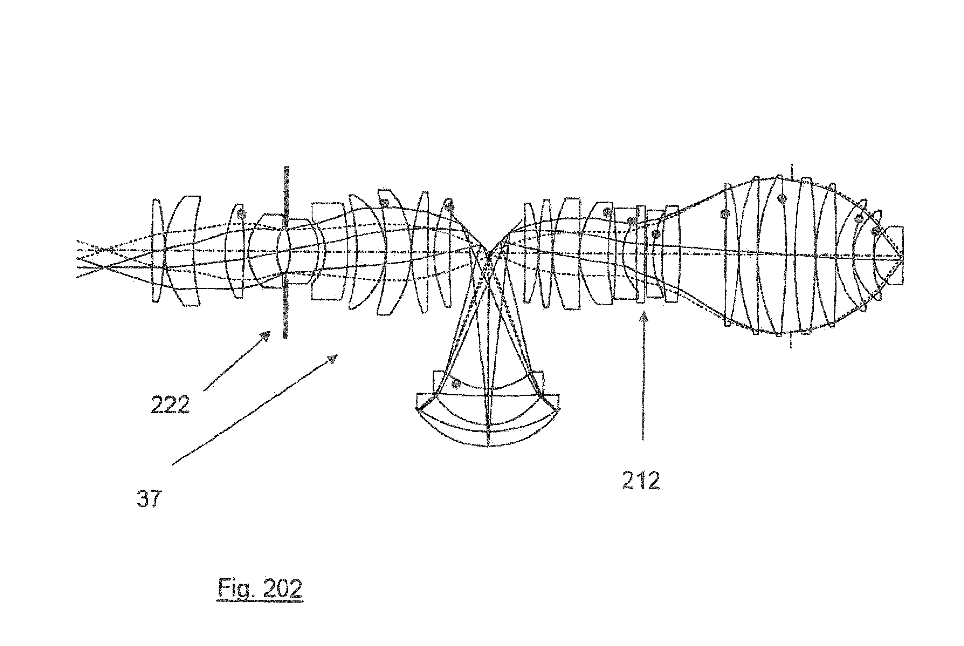

Figur 202 ein zweites erfindungsgemäßes Projektionsobjektiv für die Mikrolithographie mit einem erfindungsgemäßen optischen Element und einer erfindungsgemäßen Streulichtblende;

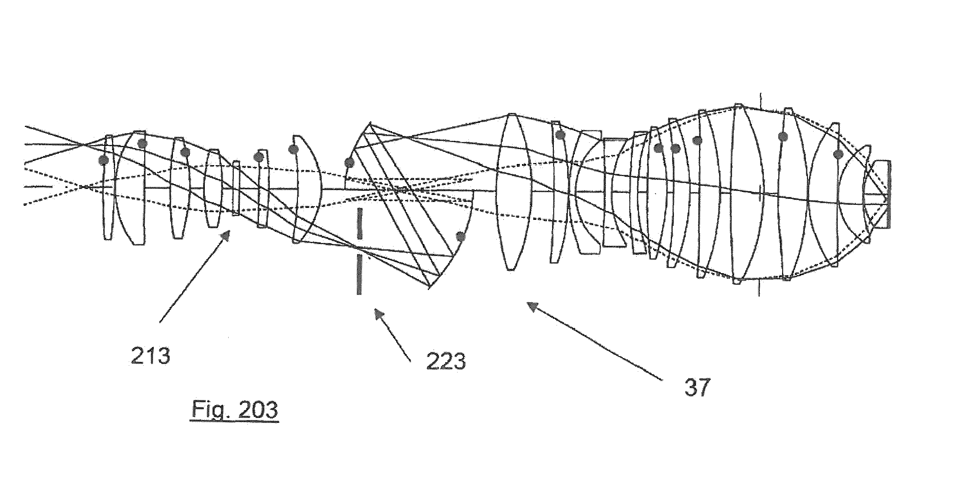

Figur 203 ein drittes erfindungsgemäßes Projektionsobjektiv für die Mikrolithographie mit einem erfindungsgemäßen optischen Element und einer erfindungsgemäßen Streulichtblende, und

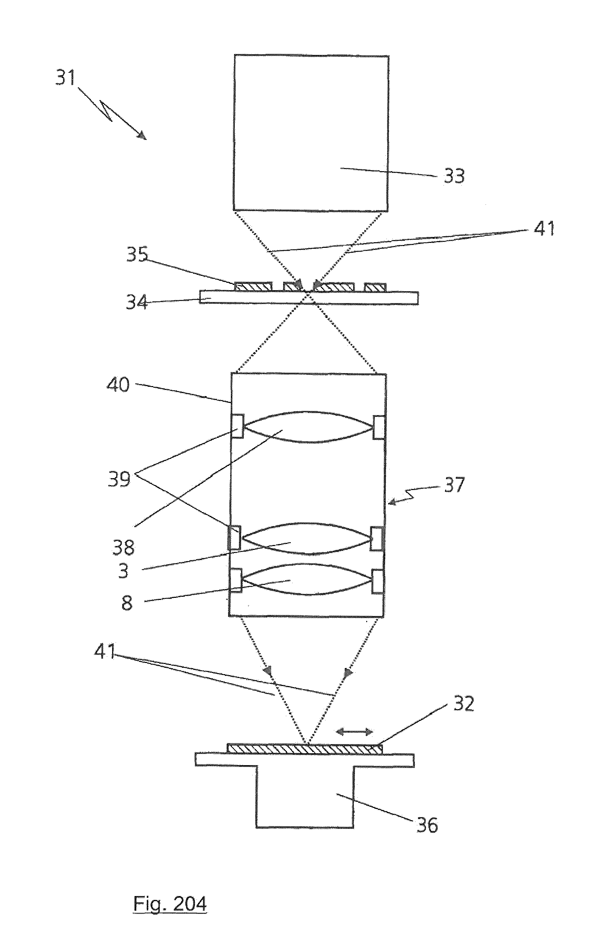

Figur 204 eine Projektionsbelichtungsanlage für die Halbleiterlithographie, in die die in den vorstehenden Ausführungsbeispielen beschriebenen optischen Elemente integriert sind.

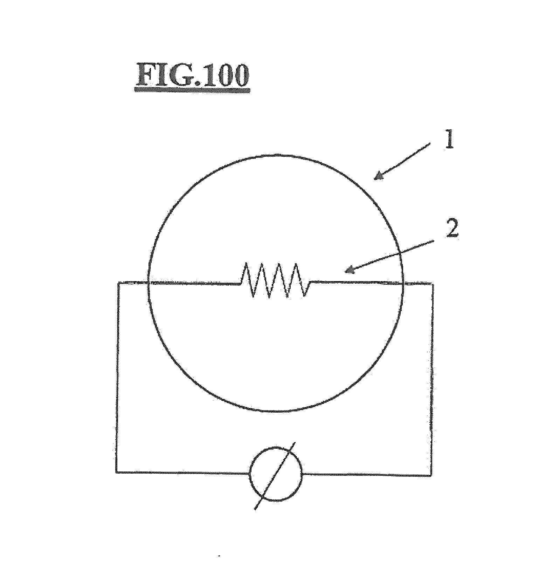

Figur 100 illustriert den generellen Ansatz der Erfindung. Ein aus einem Substrat bestehendes, optisches Element 1 wird mit einer elektrisch ansteuerbaren Leiterbahn 3 ausgestattet, welche im optischen Element einen ohmschen Widerstand ausbildet. Wird an die Leiterbahn eine Spannung angelegt, so fließt ein Strom, welcher den Ohmschen Widerstand erhitzt. Die Verwendelung der Leiterbahn lässt eine räumliche Lokalisierung der Erhitzung zu.

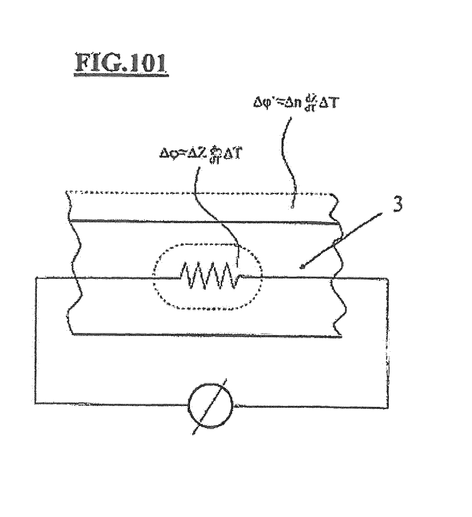

Figur 101 illustriert die beiden Wirkungen, die die Erhitzung des auf das optische Element 1 hat. Da diese beiden Wirkungen örtlich lokaler Natur sind, ist in Figur 2 nur ein Ausschnitt des optischen Elementes 1 dargestellt. Die erste der beiden Wirkungen ist die Wirkung auf den Brechungsindex

$$\Delta\varphi \approx \Delta Z \frac{dn}{dT} \Delta T$$

des optischen Elementes. Die zweite Wirkung die einer Ausdehnung und der damit verbundenen Formvariation

$$\Delta\varphi' \approx \Delta n \frac{dn}{dT} \Delta T$$

des optischen Elementes.

Figur 1 zeigt als Variante ein optisches Element 1, das zweiteilig aus einem ersten Substrat 1a und einem zweiten Substrat 1b aufgebaut ist, Dabei sind die Leiterbahnen 3 zwischen den beiden Substraten angeordnet. Das zweite Substrat 1b ist mit dem ersten Substrat 1a über eine dünne Kittschicht 4 verbunden; dabei dient die Kittschicht 4 auch dazu, den durch die Leiterbahnen 3 verursachten Höhenunterschied auf der Oberfläche des ersten Substrates 1a auszugleichen. Bei dem optischen Element 1 kann es sich insbesondere um eine Linse, einen Spiegel, eine Strahlteilervorrichtung oder auch um ein optisches Element mit einer diffraktiven Struktur handeln.

Es ist auch möglich, dass das optische Element aus einem Substrat gebildet wird, und dass sich die Leiterbahnen im Bereich einer Oberfläche dieses optischen Elementes befinden.

Figur 2 zeigt eine Variante, bei der die Leiterbahnen 3 in Ausnehmungen 5 angeordnet sind. Dabei können die Ausnehmungen 5 insbesondere durch ein Ätzverfahren hergestellt worden sein. Diese Variante hat den Vorteil, dass das erste Substrat 1a mit dem zweiten Substrat 1b ohne die Verwendung einer Kittschicht verbunden werden kann. So kann beispielsweise das zweite Substrat 1b mit dem ersten Substrat 1a durch Ansprengen verbunden werden.

Figur 3 zeigt eine Ausführungsform der Erfindung, deren Realisation mit geringem Aufwand verbunden ist. Dabei sind die Leiterbahnen 3 auf der polierten Oberfläche des Substrats 1a angeordnet. Das Substrat 1a sowie die Leiterbahnen 3 sind von der optischen Schicht 6 bedeckt. Bei der optischen Schicht 6 kann es sich beispielsweise um eine Antireflex- oder auch - im Falle von der Verwendung eines Spiegels als optisches Element 1 - um eine hochreflektive Schicht handeln. Zur Herstellung der Ausführungsform aus Figur 3 wird die optische Schicht 6 auf das bereits mit Leiterbahnen 3 versehene Substrat 1a aufgebracht; sie bedeckt die optische Oberfläche des Substrats 1a und die Leiterbahnen 3. Abhängig von dem Herstellungsprozess der optischen Schicht 6 kann die optische Schicht 6 nach ihrem Auftrag im Bereich der Leiterbahnen erhaben sein und dort mit einem ihrem Auftragen nachgeordneten Politurschritt eingeebnet werden.

Für die Gestaltung der Querschnitte der Leiterbahnen 3 gibt es verschiedene Möglichkeiten, von denen einige in Figur 4 dargestellt sind. Geätzte oder aufgedampfte Leiterbahnen 3 sind üblicherweise flach, wie in Figur 4a dargestellt. Zur Verringerung des optisch wirksamen Querschnitts kann aber auch für einen gegebenen Widerstandswert ein Profil der Leiterbahn 3 gewählt werden, bei dem die Leiterbahn 3 höher als breit ist; dieser Fall ist in Figur 4b dargestellt. Für die Fälle, in denen der Strahlengang an der betreffenden Stelle des optischen Elements 1 divergent ist, kann auch wie in Fig. 4c skizziert ein trapezförmiger Querschnitt der Leiterbahnen 3 gewählt werden. Für Bereiche am Rand des optischen Elements 1, wo vorwiegend schräger Einfall der optischen Strahlung erfolgt, kann das Profil der Leiterbahnen 3 zur Mitte des optischen Elements 1 hin geneigt ausgebildet werden, wie in Figur 4d dargestellt. Darüber hinaus ist es denkbar, die Kanten und Ecken des Profils der Leiterbahn 3 verrundet oder unregelmäßig zu gestalten, wodurch Streuung vermindert oder über breite Winkelbereiche verschmiert werden kann.

Die elektrischen Leiterbahnen können dabei mindestens abschnittsweise lateral zur Einfallsrichtung der optischen Strahlung einen Querschnitt von höchstens 1 oder zwischen 0,5 und 0,01 Mikrometer haben. Die Beabstandung der Leiterbahnen liegt zwischen 0.01 und 1 Millimetern. Es sind auch Beanstandungen zwischen 0.05 und 0.5 Millimetern möglich, oder speziell von 0.1 Millimeter.

Figur 5 zeigt in den Teilfiguren 5a und 5b Fälle, in denen Bereiche großer Wärmeleistungsdichten abgebildet werden. Dabei betrifft der Fall der Figur 5a eine in der Zeichenebene als senkrecht angenommene, nicht dargestellte, durch einen Dipol verursachte, Wärmebeaufschlagung im Fall eines Einsatzes des optischen Elementes 1 in einer Projektionsbelichtungsanlage für die Mikrolithographie. Die Leiterbahnen 3 konzentrieren sich in dem in Figur 5a dargestellten Fall auf den zu dem von der optischen Strahlung beaufschlagten Bereich komplementären Bereich. Hierdurch wird eine zumindest teilweise Homogenisierung des Gesamtwärmeeintrags erreicht. Ebenfalls dargestellt in Figur 5a sind die Anschlussdrähte 7, mit denen die im optischen Element 1 angeordneten Leiterbahnen 3 kontaktiert werden. Figur 5b zeigt eine Variante für eine feldnahe Position des optischen Elements mit einer Ausbildung der Heizzone entsprechend des Feldes in Form des Scannerschlitzes. Das optische Element 1 ist hierbei in einem feldnahen Bereich des Projektionsobjektivs angeordnet. Auch hier sind die Leiterbahnen 3 und die Anschlussdrähte 7 im optischen Element 1 dargestellt. Für den Fall der Verwendung der Leiterbahnen 3 als Heizdrähte kann die Dichte der Beheizung des optischen Elements 1 dadurch variiert werden, dass der Abstand der Leiterbahnen 3 oder deren Verwendelung, wie in Figur 5a und Figur 5b dargestellt, variiert wird. Dabei kann es sich bei der Verwendelung um eine laterale Variation im Sinne eines seitlichen Zick-Zackverlaufs der Leiterbahnen 3 handeln; darüber hinaus ist es auch denkbar, die Verwendelung dreidimensional, beispielsweise in der Art einer Spiralfeder, auszubilden.

Eine weitere Variante der Erfindung nimmt in Figur 5a bzw. Figur 5b eine gleiche azimutale Ausrichtung des Wärmeeintrags der optischen Strahlung und des Wärmeeintrags der Leiterbahnen an. In diesem Fall hat das Substrat des mit den Leiterbahnen versehenen optischen Elementes ein umgekehrtes Vorzeichen von dn/dT wie das oder die optischen Elemente, welche den von der optischen Strahlung verursachten Wärmeeintrag im Wesentlichen aufnehmen. Mögliche Paarungen sind hier Quarzglas und CaF2 oder umgekehrt.

Figur 6 zeigt ein optisches Element 1 in der Draufsicht, auf dem die Leiterbahnen 3 in der Art einer Matrix angeordnet sind. Die horizontalen und die vertikalen Leiterbahnen sind über hier nicht dargestellte Heizwiderstände bzw. Verwendelungen verbunden. Durch diese Variante der Erfindung wird durch jeweils separate Kontaktierung der Leiterbahnen 3 die Möglichkeit geschaffen, lokal an den Kreuzungspunkten der Leiterbahnen 3 zu heizen. Die in Figur 6 gezeigte Anordnung der Leiterbahnen eröffnet die Möglichkeit, streifenförmige Variationen in der Beschaffenheit des für das optische Element verwendeten Materials, wie sie bei einzelnen Herstellern auftreten können, zu kompensieren. Naturgemäß ist ein Versatz der Leiterbahnen in Richtung aus der Zeichenebene heraus notwendig, um alle Kreuzungspunkte einzeln ansteuern zu können. Bei vorab bekannten Symmetrieeigenschaften der durch die optische Strahlung hervorgerufenen Erwärmung des optischen Elementes kann eine Koppelung einzelner Leiterbahnen aber auch vorteilhaft sein. Die an die einzelnen Leiterbahnen angelegte Spannung kann zusätzlich gepulst angesteuert werden.

Figur 7 zeigt ebenfalls in der Draufsicht den Fall, dass die Leiterbahnen 3 in der Matrixstruktur über das optische Element 1 hinweg nicht äquidistant angeordnet sind. Die einzelnen Leiterbahnen sind über hier wiederum über nicht dargestellte Heizwiderstände bzw. Verwendelungen verbunden. Diese Ausführungsform der Erfindung ist besonders zur Kompensation der Auswirkungen von Quadrupol-Beleuchtungssettings im Fall eines Einsatzes des optischen Elementes 1 in einer Projektionsbelichtungsanlage für die Halbleiterlithographie geeignet. Für die notwendige, relative geometrische Lage der Wärmeinträge durch die optische Strahlung und die der Heizdrähte bzw. Heizwiderstände zueinander gelten analoge Aussagen wie bei der oben angesprochenen Dipolbeleuchtung.

Um das an den Leiterbahnen gebeugte Licht und die notwendige Stromzufuhr zu minimieren, ist es sinnvoll, die Länge der Zuleitungsdrähte zu minimieren. Für eine gleichmäßige Ansteuerung von Korrekturelementen über die Fläche ist ausgehend von einem nahezu runden optisch genutzten Bereich, wie er für pupillennahe Flächen typisch ist, ein radialer Ansatz denkbar. Dabei kann vorgesehen sein, dass die Anordnung der Leiterbahnen bzw. der thermischen Aktuatoren eine zumindest annähernde Drehsymmetrie um die optische Achse aufweisen, wobei die Zähligkeit der Symmetrie (Drehung um 360°/zähligkeit überführt die Anordnung in sich selbst) 2 oder höher ist; Figur 8 zeigt derartige Möglichkeit in der Draufsicht, die sich insbesondere zur Kompensation von Vielwelligkeiten eignet. Die einzelnen Leiterbahnen sind über hier nicht dargestellte Heizwiderstände bzw. Verwendelungen verbunden. Dabei sind die Leiterbahnen 3 im optischen Element 1 radial sternförmig angeordnet; eine Variante, bei der die Leiterbahnen 3 als rotationssymmetrisches Gitter realisiert sind, ist in Figur 9a in der Draufsicht dargestellt. Die einzelnen Leiterbahnen sind über hier nicht dargestellte Heizwiderstände verbunden. Naturgemäß können auch hier nicht alle Kreuzungspunkte der Leiterbahnen, welche durch Widerstände miteinander verbunden sind, einzeln angesteuert werden.

Eine weitere rotationssymmetrische Variante zeigt Figur 9b in der Draufsicht. In dieser Ausführungsform sind keine weiteren Heizwiderstände vorgesehen. Der örtlich unterschiedliche Wärmeeintrag wird durch die örtlich unterschiedliche Dichte der Leiterbahnen bewerkstelligt. Dies ermöglicht eine räumlich hoch aufgelöste Temperatursteuerung im optischen Element 1.

Figur 10 zeigt die oben lediglich in der Draufsicht dargestellten Ausführungsformen detailliert in einem Kreuzungspunkt der Leiterbahnen. Dabei sind die Leiterbahnen 3a und 3b in ihrem Kreuzungspunkt über einen Widerstand 8 verbunden. Alternativ kann es sich auch um eine Diode, eine Zener Diode, oder um einer Kombination aus Widerstand, einer Diode und einer Zener Diode handeln. Wenn nun die gezeichneten Leiterbahnen 3a und 3b gleichzeitig mit einem Spannungspuls beaufschlagt werden, wird der Widerstand 8 im Kreuzungspunkt der Leiterbahnen 3a und 3b selektiv geheizt. Vorzugsweise wird der Widerstand nicht nur auf den Kreuzungspunkt begrenzt sondern mäanderformig angeordnet. Dabei kann die Aufheizung entlang der Leiterbahnen 3a bzw. 3b dadurch gering gehalten werden, dass ihr Widerstand klein gegen den des Widerstands 8 gehalten wird. Es besteht die Möglichkeit, die Leiterbahnen 3 äquidistant oder nicht äquidistant anzuordnen. Für den Fall der separaten Kontaktierung der Leiterbahnen 3a bzw. 3b ergibt sich die Möglichkeit, die Leiterbahnen 3a bzw. 3b separat mit Spannungspulsen zu beaufschlagen. Auf diese Weise lässt sich bis zu einem gewissen Grad die Heizleistung im Widerstand 8 und längs der Leiterbahn 3a bzw. 3b für sich einstellen. Dadurch wird die Möglichkeit geschaffen, punktuelle Fehler über den Widerstand 8 und linienförmig ausgedehnte Fehler mit der Leiterbahn 3a bzw. 3b zu korrigieren. In Figur 10 sind lediglich exemplarisch die beiden Leiterbahnen 3a und 3b dargestellt. Zur effizienten Verteilung von Heizleistung über das optische Element 1 kann eine Vielzahl von Leiterbahnen 3 auf diesem angeordnet sein. Kann man aus Gründen der Symmetrie, z.B. Spiegelsymmetrie oder Punktsymmetrie oder Rotationssymmetrie bzgl. eines Azimuts wie 180°, 90° oder 45°, der Beaufschlagung der optischen Strahlung auf das optische Element auf Freiheitsgrade bei der Korrektur verzichten, so hat dies zur Folge, dass auch einzelne Leiterbahnen untereinander kurzgeschlossen werden können, was eine Vereinfachung der Herstellung des optischen Elementes 1 zur Folge hat.

Figur 11 zeigt eine Variante, bei der die in Figur 10 dargestellte Ausführungsform mit den Gedanken der Figur 2 kombiniert wird. Dabei wird ein Satz von Leiterbahnen 3a in Ausnehmungen 5 vergraben im Substrat 1a angeordnet. Der andere Satz Leiterbahnen 3b wird auf einer Oberfläche des zweiten Substrats 1b angeordnet. Durch Ätzen der Oberfläche mindestens eines der beiden Sätze von Leiterbahnen 3 und nachfolgendes Aufbringen einer Widerstandsschicht 9 oder durch Punktschweißen wird gewährleistet, dass der Kontaktbereich im Kreuzungspunkt der Leiterbahnen 3a bzw. 3b einen höheren Widerstand als die Leiterbahnen 3a bzw. 3b selbst aufweist. In der in Figur 10 gewählten Darstellung ist der obere Satz von Leiterbahnen 3b in dem zweiten Substrat 1b parallel zur Zeichenebene ebenfalls vergraben angeordnet, so dass auf eine Kittung der beiden Substrate verzichtet werden kann. Eine Alternative hierzu besteht darin, eine Kittschicht (nicht dargestellt) vorzusehen; in diesem Fall kann auf das Vergraben der Leiterbahnen 3a bzw. 3b in ihren jeweiligen Substraten 1a bzw. 1b verzichtet werden.

Figur 12 zeigt eine Variante der Erfindung, bei der das in Figur 10 dargestellte Vorgehen auf der Oberfläche eines optischen Elements 1 angewendet wird. Dabei sind auf der Oberfläche des optischen Elements 1 selbst die Leiterbahnen 3a angeordnet, die im Bereich der Kreuzungspunkte mit dem oberhalb verlaufenden zweiten Satz von Leiterbahnen 3b von der Widerstandsschicht 9 bedeckt werden. Die Anordnung ist von der optischen Schicht 6 als Antireflexschicht bedeckt.

Eine Alternative besteht darin, die beiden Leiterbahnen 3a bzw. 3b durch eine weitere Leiterbahn geringeren Querschnitts zu verbinden. Hierzu muss wie in Figur 11 und 12 dargestellt vorgegangen werden mit dem Unterschied, dass statt der Widerstandsschicht 9 eine Isolierschicht notwendig ist. Die weitere Leiterbahn kann dabei dadurch erzeugt werden, dass die Isolierschicht lokal durch Punktschweißen, Laserschweißen, Funkenüberschlag oder einen lithographischen Herstellungsprozess durchbrochen wird, wodurch sich an den Kreuzungspunkten ein Bereich zwischen den Leiterbahnen 3a und 3b ergibt, der einen zwar endlichen, aber wesentlich höheren Widerstand als der Bahnwiderstand der Leiterbahnen aufweist.

Figur 13 zeigt ein optisches Element 1, bei dem Leiterbahnen 3 auf beiden Seiten und im Innenbereich angeordnet sind. Dabei können die Leiterbahnen 3 flach oder der einfallenden Wellenfront angepasst ausgebildet sein. Hierdurch wird die Möglichkeit geschaffen, beispielsweise durch Heizen, die Dichte des Materials des optischen Elements 1 und damit den Brechungsindex dreidimensional zu beeinflussen. Dies ermöglicht die Korrektur von Homogenitäts- oder Spannungsfehlern auch bei optischen Elementen 1, die unter großen Winkeln durchstrahlt werden.

In Figur 14 sind verschiedene Varianten dargestellt, wie die Matrixstruktur der Leiterbahnen 3 örtlich variabel gestaltet werden kann, wodurch sich die optische Wirkung der Leiterbahnen 3 über einen größeren Winkelraum verteilt. So kann beispielsweise die Dichte der Leiterbahnen 3 variiert werden bzw. auch eine unterschiedlich starke Verwendelung der Leiterbahnen 3 in Frequenz und Amplitude variiert werden um die lokalen Heizleistungsdichten optimal an die Erfordernisse anzupassen. Die Form der Verwendelung der Leiterbahnen 3 kann dabei beispielsweise sinusförmig oder auch Sägezahn-, Dreiecks- oder entlang anderen Funktionen gewählt werden. Selbstverständlich besteht auch die Möglichkeit, das Profil der Leiterbahnen 3 zu variieren.

Figur 15 zeigt eine Variante, bei der auf Widerstände oder eine Widerstands- oder Isolierschicht verzichtet werden kann. Dabei werden die Leiterbahnen 3a und 3b in der Umgebung ihrer Kreuzungspunkte mit einem verringerten Querschnitt ausgebildet. Der Kreuzungspunkt selbst wird leitend realisiert; dies kann beispielsweise durch Aufdampfen übereinander oder Punktschweißen realisiert werden. Alternativ kann die gewünschte Struktur dadurch hergestellt werden, dass eine Metallisierungsschicht flächig aufgebracht, z. B. aufgedampft wird, aus der nachfolgend bspw. durch einen Ätzprozess die Struktur erzeugt wird. Auf besonders einfache Weise kann eine im gesamten Bereich des optischen Elements 1 gleich dicke Leiterbahn aufgebracht werden, die lediglich in ihrer Breite variiert wird. Nachteil dieser Variante ist, dass sich die Verjüngungen 17 bzw. 18 der stromführenden Leiterbahnen 3a bzw. 3b gleich stark aufheizen. Eine Selektivität kann dadurch erreicht werden, dass nicht gleichzeitig jeweils die Leiterbahnen 3a bzw. 3b auf eine Spannung gelegt werden, sondern jeweils nur ein Ende der Leiterbahnen 3a bzw. 3b. Mit anderen Worten wird in einem ersten Puls eine Spannung zwischen den Punkten 10 und 11 und in einem zweiten Puls eine Spannung zwischen den Punkten 12 und 13 angelegt. Während des ersten Pulses fließt ein Strom in die durch den Pfeil 15 angedeutete Richtung, während des zweiten Pulses in die Richtung des Pfeils 16. Durch diese Maßnahme wird im zeitlichen Mittel an dem Kreuzungspunkt 19 die doppelte Leistung freigesetzt wie an den Verjüngungen 17 und 18.

Eine mögliche Problematik bei der vorliegenden Erfindung ist die des Übersprechens von zwischen einzelnen Leiterbahnen. Diese Problematik wird insbesondere dann relevant, wenn die in einer Draufsicht betrachtete Flächendeckung im optischen Element sehr groß wird.

Anhand von Fig. 16 wird nachfolgend eine Möglichkeit erläutert, ein 2-dimensionales Feld von individuell ansteuerbaren Heizzonen 101 zu realisieren, das den sehr hohen Anforderungen an die maximale Flächendeckung, also des Anteils der Oberfläche des optischen Elementes 1, der von den Leiterbahnen 3 bedeckt ist, der Homogenität der Flächendeckung, der Homogenität der Temperaturverteilung und des gegenseitigen Übersprechens, also des Freisetzens unerwünschter Heizleistung in einer nicht angesteuerten Heizzone 101, genügt.

Für eine reguläre gitterförmige Struktur der Leiterbahnen 3, beispielsweise in der Pupillenebene eines Projektionsobjektives, ist der resultierende Streulichtanteil im Feld in erster Näherung proportional zur Flächendeckung. Typische Streulicht-Level moderner Objektive von deutlich unterhalb von einem Prozent lassen nur eine maximale Flächendeckung von wenigen Promille zu. Des Weiteren ist die Flächendeckung möglichst homogen.

Abhängig von der Beleuchtungs-Einstellung und den abzubildenden Strukturen sind die Lichtintensitäten in dieser Pupillenebene lokal unterschiedlich, und speziell bei Dipol-Beleuchtungssettings relativ stark fokussiert. Beispielsweise wählt man eine Flächendeckung der Heizelemente, welche sich auf alle Beugungsordnungen gleichmäßig auswirkt.

Daher muss die Flächendeckung, gemittelt über die typische Größe eines Dipol-Spots, über den gesamten optisch freien Bereich, also über den gesamten von der optischen Nutzstrahlung durchtretenen Bereich, innerhalb weniger Prozent homogen sein.

Da die Leiterbahnen 3 einen lokalen Wärmeeintrag in das Material des in Figur 16 nicht dargestellten optischen Elementes 1 verursachen, bildet sich an dessen Oberfläche eine so genannte Temperaturwelligkeit, also eine Variation der lokalen Temperatur, aus. Die Eindringtiefe dieser Temperaturwelligkeit in das optische Element 1 entspricht dabei etwa dem Abstand der Leiterbahnen 3. Um den Einfluss der Temperaturwelligkeit auf die optische Wellenfront klein zu halten, muss somit der Abstand der Leiterbahnen dicht genug gewählt werden. Vorteilhaft ist aus dem gleichem Grund eine möglichst regelmäßige Anordnung der Leiterbahnen 3.

Das geschilderte Problem wird erfindungsgemäß, wie in Fig. 16 beispielhaft an einem Heizfeld 100 mit 3x3 Heizzonen 101 veranschaulicht, durch eine Ausbildung der Leiterbahnen 3 als eine alternierende Anordnung von Abschnitten von Zuleitungsdrähten 301 und Heizdrähten 302 gelöst. Die Zuleitungsdrähte 301 sind dabei niederohmig gewählt, um einen möglichst geringen Wärmeeintrag in den durchlaufenen nicht angesteuerten Heizzonen 101 zu verursachen. Die Heizdrähte 302 hingegen sind bspw. wie in Figur 16 dargestellt durch eine Querschnittsverringerung hochohmig gewählt, um die gewünschte Wärmeleistung lokal in der zugeordneten Heizzone 101 zu erzeugen und in das in Figur 16 nicht dargestellte optische Element 1 einzuleiten.

Die einzelnen, wie dargestellt abschnittsweise als Zuleitungsdrähte 301 und Heizdrähte 302 ausgebildeten Teilabschnitte der Leiterbahnen 3, sind dabei jeweils für eine Heizzone 101 gemeinsam über eine Brücke 303 elektrisch kontaktiert, welche ihrerseits über ein Anschlusspad 304 mit einer nicht dargestellten Spannungsquelle verbunden werden kann. Auf der gegenüberliegenden Seite erfolgt die Kontaktierung der Leiterbahnen 3 mittels der gemeinsamen Stromschiene 305, die für alle Leiterbahnen 3 gemeinsam verwendet werden kann.

Im Ausführungsbeispiel ist der Widerstand des Zuleitungsdrahtes 301 bzw. der Zuleitungsbahn 301 im Verhältnis zum Widerstand des Heizdrahtes 302 möglichst klein gewählt, um ein unerwünschtes Aufheizen desjenigen Bereiches, der von den Zuleitungsdrähten 301 durchlaufen wird, möglichst gering zu halten. Ein wesentlich geringeres Aufheizen im Bereich der Zuleitungsdrähte 301 ist auf die in Richtung der Leiterbahnen 3 hintereinander liegenden Heizzonen 101 begrenzt und innerhalb der Heizzonen 101 homogen. Dadurch ist es möglich, den parasitären Heizleistungsanteil durch eine Entkopplungstransformation ansteuerungsseitig zu entkoppeln; mit anderen Worten können durch geeignete Regelung aufgrund der Kenntnis der Ansteuerung der gewünschten Heizzonen 101 die parasitären Effekte in den Heizzonen 101 der selben, hintereinander angeordneten Heizzonen kompensiert werden.

Der maximale, parasitäre Heizleistungsanteil innerhalb einer Heizzone 101 sollte dabei nicht größer als 10%-20% der gewünschten Heizleistung sein.

Der parasitäre Heizleistungsanteil ist proportional zur Anzahl der Heizzonen 101 innerhalb einer Spalte minus eins und dem Zuleitungswiderstand und dem Heizwiderstand entlang einer Heizzone 101. Für ein Heizfeld mit einer lateralen Ausdehnung von 10 Heizzonen 101 und einem angestrebten Übersprechen von 10% ergibt sich ein erforderliches Widerstandsverhältnis von $R_{feed}$ (Widerstand des Zuleitungsdrahtes 301) d/$R_{heat}$ (Widerstand des Heizdrahtes 302)= 1/90, bei einem Heizfeld mit einer lateralen Ausdehnung von 15 Heizzonen 101 ergibt sich eine $R_{feed}/R_{heat}$ = 1/140. Der Widerstand von Zuleitungsdrähten 301 und Heizdrähten 302 kann über die Linienbreite, die Schichtdicke, die Materialwahl und über die effektive Leitungslänge eingestellt werden. Derartige erfindungsgemäße optische Elemente besitzen 100 bis 225 Heizzonen.

Der maximale Wert der absoluten Widerstände R = U/I ist begrenzt durch die erforderliche Spannung U, um eine vorgegebene Heizleistung zu realisieren. Bei einer Betriebsspannung von kleiner oder gleich 200V lassen sich die Elektronik- und Anschlusskomponenten kompakt realisieren. Höhere Betriebsspannungen sind zwar denkbar, erfordern jedoch einen zunehmend höheren Aufwand, um elektrische Überschläge zu vermeiden und die Spannungsfestigkeit der elektronischen Komponenten zu gewährleisten.

Nach unten hin ist der minimal mögliche Zuleitungswiderstand begrenzt durch den maximal erlaubten Drahtquerschnitt, der wiederum durch die erlaubte Flächendeckung begrenzt ist sowie durch die spezifischen Widerstände geeigneter leitender Materialien. Reine Elemente weisen dabei die niedrigsten möglichen spezifischen Widerstände auf, die Widerstände von Legierungen liegen im allgemeinen höher als die der Elemente. Für eine vorgegebene Länge der Heizzonen 101 und einer vorgegeben Querschnittsbegrenzung ist der minimal mögliche Widerstand durch die spezifischen Widerstände verfügbarer leitender Materialien begrenzt. Als Materialien für die Zuleitungsdrähte 301 eignen sich beispielsweise Metalle mit einem geringen spezifischen Widerstand wie Ag, Cu, Au, Al, Wo, Mo, Sn oder Ni.

Allgemein ist ein möglichst niedriger Zuleitungswiderstand anzustreben. Höhere Widerstände der Heizdrähte 302 können durch reduzierte Querschnitte der Heizdrähte 302 relativ zu den Querschnitten der Zuleitungsdrähte 301 erreicht werden. Darüber hinaus kann die effektive Länge des Heizdrahtes 302 durch eine mäanderförmige Gestaltung verlängert werden, um hiermit den Gesamtwiderstand des Heizdrahtes 302 zu erhöhen. Über die effektive Länge lassen sich die Heizdrahtwiderstände theoretisch beliebig vergrößern, was jedoch zu Lasten der Flächendeckung geht, weshalb Längenfaktoren zwischen 1-50 bevorzugt werden.

zusätzlich kann ein zweites Leitermaterial, dessen spezifischer Widerstand größer ist als der der Zuleitungsdrähte 301, für die Heizdrähte 302 in den zu beheizenden Zonen 101 gewählt werden. Als Materialien für die Heizdrähte 302 können beispielsweise Metalle mit höherem spezifischem Widerstand wie beispielsweise Ni, Pt oder Cr oder Halbleiter wie Si oder Ge gewählt werden. In einer alternativen Ausführung sind die spezifischen Widerstände der verwendeten Materialien durch Dotierung mit Fremdelementen für die Erfordernisse optimal angepasst. Im Falle von Metallen kann der spezifische Widerstand durch Dotierung oder durch Einbringen von Legierungsbestandteilen künstlich erhöht werden, im Falle von Halbleitern kann der spezifische Widerstand durch das Einbringen von Dotierungselementen künstlich reduziert werden.

Dies kann dadurch erreicht werden, dass einige der Leiterbahnen, insbesondere die Zuleitungsdrähte und/oder die Heizdrähte, dotiert sind.

Eine Ausführungsform des Zuleitungsdrahtes 301, eines mäanderförmigen Heizdrahtes 302 und des Übergangsbereiches 306 zwischen den einzelnen Abschnitten ist in Fig. 17 gezeigt. Um hohe Stromdichten an den innen liegenden Ecken des Heizdrahtes 302 zu vermeiden, ist der Verlauf der Heizdrähte 302 mindestens abschnittsweise durch Radien abgerundet.

Alternativ können auch Fasen vorgesehen werden. Des Weiteren ist im Übergangsbereich 306 der beiden Materialien eine Übergangszone mit größerem Überlappungsbereich vorzusehen, um in diesem Bereich die Stromdichten zu reduzieren und somit das Risiko elektro-chemischer Degradation an der Grenzschicht zu eliminieren. Der vergrößerte Überlappungsbereich entschärft die Overlay-Anforderungen, falls Zuleitungsdrähte 301 und Heizdrähte 302 in zwei separaten Lithographieprozessen strukturiert werden.

Da bei den Heizdrähten 302 je nach Erfordernis sehr dünne Linien mit möglichst geringen Schichtdicken angestrebt werden, um den elektrischen Widerstand auf das gewünschte Niveau einzustellen, besteht hier ein erhöhtes Risiko von Defekten durch Einschnürungen, Materialverdünnung, Schichtfehler, Resist-Fehler, Partikel und Stitching-Fehlern. Eine gegenüber solchen lokalen Defekten robuste Anordnung ist in Figur 18 dargestellt. Anstelle eines einzelnen Mäanders sind nun mehrere mäanderförmige Abschnitte des Heizdrahtes 302 parallel angeordnet und in regelmäßigen Abständen mit Bypässen 307 quer verbunden. Tritt ein lokaler Defekt in einer der Abschnitte auf, so umläuft der Strom diese Stelle über die Bypässe 307 und die benachbarten mäanderförmigen Abschnitte.

Je nach Anzahl der Heizzonen 101 pro optischem Element 1 und der Anzahl der Heizdrähte 302 pro Heizzone 101 müssen einige hundert bis hin zu einigen tausend Drähte elektrisch kontaktiert werden. Wie in Fig. 16 gezeigt, können auf einer Seite des Heizfelds 100 alle Zuleitungsdrähte an einer gemeinsamen Stromschiene 305 zusammengefasst werden. Auf der gegenüber liegenden Seite können alle Leiterbahnen 3, die derselben Heizzone 101 zugeordnet sind, mittels Brücken 303 zusammengefasst werden. Hierdurch wird die Anzahl der Anschlussleitungen auf die Anzahl der aktiv angesteuerten Heizzonen 101 reduziert.

In einer weiteren Ausführungsform sind die Brücken 303 mit Hilfe einer zweiten Lage mit Leiterstrukturen realisiert, die durch ein geeignetes Dielektrikum gegenüber der ersten Lage mit den Leiterbahnen 3 elektrisch isoliert ist. Durch Kontaktierungslöcher werden alle Zuleitungsdrähte 301, die zu einer Heizzone 101 gehören, mit der Brücke 303 verbunden. Der elektrische Anschluss zur Treiberelektronik hin kann dann durch eine Kontaktfläche auf der zweiten Lage oder eine freigelegte Kontaktfläche auf der ersten Lage vorgenommen werden; eine prinzipielle Darstellung dieser Lösung zeigt Figur 19.

In einer alternativen Ausführungsform werden die Brücken 303 durch Bonding Wires realisiert, wodurch die Strukturierung einer zweiten Lage eingespart werden kann.

In einer weiteren alternativen Ausführungsform werden die Brücken 303 im Anschluss-Board realisiert. Die Anzahl der Kontaktierungspunkte entspricht in diesem Fall zwar der Anzahl der Leiterbahnen 3, die Anzahl der herausgeführten Leitungen ist jedoch auf die Anzahl der Heizzonen 101 reduziert.

Nach der Reduktion der Leitungen durch die zuvor geschilderten Maßnahmen ist die Anzahl der herausgeführten Leitungen entsprechend der Anzahl der Heizzonen bzw. Heizdrähte typischerweise hundert bis zu mehreren tausend. Es besteht daher zusätzlich die Aufgabe, eine Vielzahl von Anschlussleitungen möglichst kräftefrei an das erfindungsgemäße optische Element 1 elektrisch anzubinden, da über die elektrische Zuleitung eingebrachte Kräfte und Momente Deformation, Verkippung und Positionsänderungen des optischen Elementes 1 verursachen können, welche wiederum zu optischen Aberrationen führen.

In einer ersten Ausführungsform wird die elektrische Verbindung mittels Wire-Bonding auf ein Übergabe-Board bewerkstelligt, wobei das Übergabe-Board von dem optischen Element 101 mechanisch entkoppelt ist. Da die Bonding Wires sehr dünn gewählt werden können und die bogenförmige Geometrie günstig hinsichtlich der Minimierung der mechanischen Steifigkeit ist, stellen Bonding Bridges elektrische Verbindungen mit minimaler mechanischer Steifigkeit und somit optimaler mechanischen Entkopplung dar.

Alternativ können auch flexible Leiterfolien 350 zur elektrischen Anbindung verwendet werden, wie in Fig. 20 gezeigt. Auf diese Weise können dabei alle einer Heizzone 101 zu geordneten Zuleitungsdrähte 301 hintereinander fluchtend auf derselben Kontaktierungsbahn 351 auf der flexiblen Leiterfolie angeordnet werden, wodurch sich der Kontaktierungsaufwand verringert. Ferner können die einer Reihe zugehörigen Kontaktierungsbahnen auf derselben Leiterfolie 350 angeordnet werden. Um die Flächensteifigkeit der flexiblen Leiterfolien 350 zu reduzieren, kann eine S-Form oder mehrere Wellen ähnlich einem Faltenbalg eingeprägt werden. Des Weiteren ist die flexible Leiterfolie 350 entlang der Kontaktierungsreihe in Sektionen geschlitzt, um zu vermeiden, dass über die Flächensteifigkeit der flexiblen Leiterfolie 350 Scherspannungen aufgebaut werden, die eine Deformation des optischen Elementes zur Folge haben können. Geeignete elektrische Kontaktierungsmethoden der flexiblen Leiterfolie 350 an die Kontaktpunkte der erfindungsgemäßen optischen Elemente sind elektrisch leitender Kleber, anisotrop leitender Kleber oder Klebebänder, anisotrop leitende Bänder, Lötverbindungen durch Stempellöten, Ofenlöten, Heissluftlöten oder Laserlöten sowie Wire-Bonding.

Um Kriechströme und Überschläge zu vermeiden können die Leiterbahnen auf dem optischen Element in eine $SiO_2$ Schicht oder Schicht eines anderen optisch transparenten Dielektrikums eingebettet sein. Solch eine Schicht überdeckt eventuelle Oberflächendefekte und Rauhigkeiten, die durch den Strukturierungsprozess verursacht sind, und kann zur Erreichung der benötigten Oberflächengenauigkeit des optischen Elementes überpoliert werden.

Eine zusätzlich auftretende Problematik der Erfindung ist die mit einer zunehmenden Flächendeckung der Leiterbahnen das von den Leiterbahnen erzeugte Streulicht. Die nachfolgenden Ausführungsformen der Erfindung werden für Projektionsobjektive für die Mikrolithograhie formuliert. Sie sind aber auch für andere optische Systeme denkbar.

Der Streulichtanteil, der durch die Leiterbahnen in der Wafer-Ebene einer Projektionsbelichtungsanlage verursacht wird, kann neben der Flächendeckung auch von der Orientierung der Leiterbahnen relativ zur Scan-Richtung abhängig sein, Eine Feldblende in einer dem erfindungsgemäßen optischen Element nachfolgenden Feldposition kann einen beachtlichen Teil des durch die Leiterbahnen verursachten Streulichtes abfangen, so dass dieses nicht auf den zu belichtenden Wafer fällt. Eine günstige Form der Feldblende entspricht dabei dem Bild des Objektfeldes, insbesondere des Scannerfeldes. Da der Scannerschlitz in Scanrichtung deutlich schmaler ist als senkrecht dazu, ist es möglich, die Drähte senkrecht zur Scanrichtung anzuordnen, so dass das Streulicht in Scanrichtung gebeugt wird, wobei durch die in dieser Richtung schmalere Feldapertur ein deutlich grösserer Teil abgefangen wird als senkrecht dazu.

Nachfolgend sollen weitere Möglichkeiten angegeben werden, mittels derer das durch die erfindungsgemäßen optischen Elemente bspw. durch Streuung oder Beugung an den Leiterbahnen bzw. thermischen Aktuatoren verursachte so genannte Streulicht, oder synonym Falschlicht, reduziert werden kann:

Falschlicht ist typischerweise Licht, dessen Ausbreitungsrichtung am Ort der Beugung von der Nutzrichtung, also von der für die optische Nutzstrahlung vorgesehenen Richtung, abweicht. Findet diese Beugung pupillennah statt, so wird diese Richtungsänderung in eine Ortsänderung im Bild übersetzt, was zu so genannten Doppel- oder Geisterbildern führt. Falschlicht lässt sich dann abfangen, wenn es Orte passiert, die kein Nutzstrahlengang trifft. Beispielsweise sind diese Orte im Bereich von Zwischenbildern, wenn das Falschlicht pupillennah erzeugt wird, und Pupillenbereiche für feldnah erzeugtes Falschlicht. Erfindungsgemäß können beugend wirkende Korrekturmittel mit Falschlichtblenden an diesen entsprechenden Orten kombiniert werden. Für den Fall, dass das erfindungsgemäße optische Element in einem optischen System wie bspw. in einen Projektionsobjektiv in Lichtrichtung vor einem ersten Zwischenbild positioniert ist, kann eine Falschlichtblende in Zwischenbildnähe von Vorteil sein.

Ein beispielhaftes Verfahren zur Auslegung solcher Falschlichtblenden umfasst die folgenden Schritte:

1. Auslegung des optischen Korrekturelements
2. Bestimmung seiner beugenden Wirkung
3. Berechnung des Nutzstrahlenganges sowie der Lichtwege des gebeugten Lichts durchs System. Dies kann etwa dadurch geschehen, dass Testflächen im Rahmen einer strahlbasierten Simulation im System plaziert werden und jeweils diejenigen Bereiche auf diesen Testflächen berechnet werden, auf denen Nutzstrahlung und Falschlicht durchtreten.
4. Ermitteln von Objektivbereichen, durch die Falschlicht, jedoch kein Nutzlicht läuft. Dies kann durch Bildung der Differenzmengen der in Punkt 3 beschriebenen Testflächenbereiche geschehen.
5. Prüfung, ob diese Objektivbereiche zur Platzierung von Falschlichtblenden geeignet sind. Gegebenenfalls Vorsehen einer Falschlichtblende an diesen Orten.

Durch die Auslegung und Positionierung der Falschlichtblenden sollen also im Wesentlichen die folgenden Bedingungen erfüllt werden:

- Licht im Nutzstrahlengang läuft unbeeinflusst durch die Falschlichtblende
- zumindest ein Teil des Lichtes, welches bei regulärer Bestrahlung von den Leiterbahnen bzw. den thermischen Aktuatoren gebeugt wird, trifft auf die Falschlichtblende.

In den angesprochenen Systemen mit rechteckigem Feld ist orthogonal zur Scanrichtung das Feld größer als in der Scanrichtung. Entsprechend lässt sich in dieser "kurzen" Richtung des Feldes leichter Falschlicht abfangen als senkrecht dazu. Streulicht durch geradlinige Leiterbahnen, welche senkrecht zur Scanrichtung orientiert sind, kann daher leichter abgefangen und damit reduziert werden.

Eine Variante der Erfindung besteht dabei darin, dass das erfindungsgemäße optische Element in oder nahe einer Pupillenebene positioniert ist, während die Falschlichtblende feldnäher ausgelegt wird und zumindest teilweise in Richtung der kurzen Feldrichtung seitlich neben dem Nutzstrahlengang angebracht wird.

Auch die Verwendung mindestens einer Aperturblende, die in Lichtrichtung nach dem erfindungsgemäßen optischen Element angeordnet ist, stellt eine wirksame Möglichkeit zur Unterdrückung von Falschlicht dar.

Auch die letzte Fläche eines optischen Projektionsobjektivs stellt einen Ort dar, wo Falschlicht abgefangen werden kann.

Im Folgenden sollen weitere alternative Realisationsformen der erfindungsgemäßen optischen Elemente vorgestellt werden:

Zum Aufbringen der Leiterbahnen bzw. der thermischen Aktuatoren sind Planparallelplatten als optische Elemente geeignet. Eine Alternative hierzu besteht darin, die Leiterbahnen bzw. die thermischen Aktuatoren auf gekrümmten, gegebenenfalls asphärischen Flächen anzuordnen. Die gekrümmten Oberflächen können dabei einen Krümmungsradius kleiner als 10000 mm, bevorzugt kleiner als 5000 mm zeigen. Hierzu ist es möglich, ein Element an ein anderes gekrümmtes Element anzusprengen, plan zu bearbeiten und zu strukturieren. Nach dem Absprengen wird sich eine gekrümmte, strukturierte Oberflächenform einstellen. Gründe für die Anordnung der Leiterbahnen bzw. der thermischen Aktuatoren auf gekrümmten Flächen können Bauraummangel im sinnvollen Subaperturbereich oder eine gewünschte Verstärkung der Brechzahländerung bei begrenzter Leistung sein, beispielsweise wenn im betreffenden Bereich eine starke Strahlumlenkung stattfindet und das betreffende Element dadurch besonders empfindlich auf Änderungen in der Brechzahl reagiert.

Ferner können optische Elemente aus anderen Gründen auf unterschiedliche Einzelelemente aufgeteilt werden und sich durch diese ohnehin erforderliche Aufteilung als Träger von Korrekturmitteln wie bspw. Leiterbahnen oder thermischen Aktuatoren anbieten.

Auch die Verwendung von kristallinen Optikmaterialien wie Kalziumfluorid, Bariumfluorid, Barium- Lithiumfluorid, andere Fluoride, LuAG (Luthetiumaluminiumgranat) oder Spinell, welche im Ultraviolettbereich intrinsische Doppelbrechung zeigen, ist zur Realisation des erfindungsgemäßen optischen Elements denkbar. Um die resultierende Doppelbrechung im System klein zu halten, wurde bereits vorgeschlagen, diese Elemente in Teileelemente unterschiedlicher Kristallorientierung und unterschiedlicher Drehstellung um die optische Achse so zu zerlegen, dass der summarische Effekt tolerable Grenzen nicht übersteigt. Beispielsweise können die kristallographischen Hauptachsen in [100] -, [111]- oder [110]- Richtung in Richtung der optischen Achse des Systems orientiert sein, die entsprechenden Kompensationsschemata finden sich vielfältig in der Literatur.

In einer alternativen Variante der Erfindung ist es auch denkbar, die unvermeidlichen durch die Leiterbahnen bzw. die thermischen Aktuatoren verursachten Beugungseffekte als erwünschte diffraktive optische Effekte einzusetzen. Mit anderen Worten hätte die auf dem optischen Element aufgebrachte Leiterstruktur sowohl eine erwünschte optische als auch eine erwünschte thermische Wirkung.

Korrekturstrategien zur Auslegung bzw. Anwendung der erfindungsgemäßen optischen Elemente:

Für die Korrekturstrategien zur Auslegung bzw. Anwendung der erfindungsgemäßen optischen Elemente ist insbesondere zu beachten, dass deren Korrekturpotential begrenzt ist, da beispielsweise der maximal zulässige Strom einen limitierenden Faktor darstellt. In einem Beispiel ist daher vorgesehen, die erfindungsgemäßen optischen Elemente mit herkömmlichen Manipulatoren (Wellenlänge, Gaszusammensetzung, -druck und -temperatur, Starrkörperbewegungen optischer Elemente oder deren Verbiegung vom Rand her) zu kombinieren und die verfahrwegsintensive Grobabstimmung mit diesen herkömmlichen Manipulatoren durchzuführen, wohingegen nur feinere Korrekturen mittels der erfindungsgemäßen optischen Elemente erfolgen. Ist bekannt, dass gewisse Korrekturfreiheitsgrade zwar prinzipiell in beide Richtungen angeregt werden können, aber nur in einer benötigt werden, so kann man im System (entweder am erfindungsgemäßen optischen Element selbst oder an einem anderen Optikteil an äquivalenter Subaperturposition) einen Vorhalt in die benötigte Richtung etwa durch Asphärisierung erzeugen, so dass sich der Nullzustand bereits durch Anfahren des Manipulators in die sonst unnütze Korrekturrichtung ergibt. Die gewünschte Korrekturwirkung kann dann durch Zurückfahren des Manipulators aus dieser "unnützen" Korrekturrichtung heraus erreicht werden. Gegenüber einer Vorgehensweise ohne den oben erwähnten Vorhalt ergibt sich ein doppelter Verstellrange, der für eine Wellenfrontkorrektur zur Verfügung steht.

Um Fertigungsvariationen auszugleichen, ist es zweckmäßig, für das erfindungsgemäße optische Element vorab einen Kalibrierungsdatensatz zu erstellen. Dazu steuert man mit definierter Stromstärke die einzelnen lokalen Bereiche an und vermisst interferometrisch den resultierenden Einfluss auf die Wellenfront. Auf Basis dieser Informationen werden die lokalen Bereiche später so angesteuert, dass eine hochgenaue optische Wirkung der lokalen Temperaturänderungen erzielt wird.

In einem Beispiel kann das erfindungsgemäße optische Element als Tauschteil ausgelegt sein. So kann das erfindungsgemäße Korrekturmittel in einem Beispiel an den bevorzugten Einsatz der Projektionsbelichtungsanlage angepasst sein, d.h. beispielsweise an Dipol- oder Quadrupolbeleuchtung. Zusätzlich können die Tauschteile unterschiedliche asphärische Wirkung durch unterschiedliche Flächenformen aufweisen oder zur Korrektur spezifischer Veränderungen des Projektionsobjektives durch beispielsweise Compaction ausgelegt sein.

Falls das optische Element als Planparallelplatte ausgeführt ist, kann es sinnvoll sein, es in einem divergenten oder konvergenten Strahlengang entlang der optischen Achse verschiebbar auszulegen. Durch eine Verschiebung entlang der optischen Achse ändern sich dann aufgrund des divergenten Strahlenganges die Subaperturverhältnisse merklich, so dass das optische Element jeweils für den Systemzustand optimalen Bereich operieren kann. Solch eine Verschiebung kann dann sinnvoll sein, wenn etwa Lebensdauer- und Linsenerwärmungseffekte in unterschiedlichen Subaperturbereichen dominant sind und je nach Nutzung und Dauer, die das System schon im Einsatz ist, mit unterschiedlichem Gewicht stören. Generell kann das optische Element zusätzlich in seiner Position variierbar sein (Dezentrierung, Kipp bevorzugt um eine Achse parallel oder senkrecht zur optischen Achse, Drehung) oder/und insbesondere astigmatisch, drei- oder vierwellig deformierbar (im Rahmen der Belastungsgrenzen der Leiterbahnen bzw. thermischen Aktuatoren) ausgelegt sein. Die genannten Verschiebungen/Drehungen/Verkippungen des optischen Elementes können selbstverständlich auch dann vorgesehen sein, wenn sich das optische Element in einem nicht divergenten oder konvergenten Teil des Strahlenganges befindet.

Falls die Projektionsbelichtungsanlage in unterschiedlichen Betriebsmodi genutzt wird, von denen ein erster Modus z.B. mit gleichmäßiger Linsenerwärmung einen geringen Wellenfrontfehler generiert, aber empfindlich auf Falschlicht reagiert, während ein zweiter Betriebsmodus starke Erwärmungseffekte generiert, aber kann es sinnvoll sein, einen schnellen Tausch des erfindungsgemäßen optischen Elementes gegen ein optisches Element vorzusehen, welches unstrukturiert ist und über dieselbe gewünschte optische Wirkung wie das nicht angesteuerte erfindungsgemäße optische Element verfügt. Im ersten Betriebsmodus wird das unstrukturierte und damit kein Falschlicht generierende optische Element in den Strahlengang genutzt. Im zweiten Modus wird das erfindungsgemäße optische Element eingesetzt und der durch die beispielsweise ungleichmäßige Erwärmung des zweiten Modus hervorgerufenen Wellenfrontfehler durch das Element korrigiert.

Es ist somit vorteilhaft, wenn das erfindungsgemäße optische Element in der Weise ausgelegt wird, dass es während des Betriebs der Projektionsbelichtungsanlage ausgetauscht werden kann, also insbesondere in einer mechanischen Wechselfassung gehalten wird und Vorkehrungen für eine einfache Zugänglichkeit getroffen werden.

Um das erfindungsgemäße optische Element sinnvoll auslegen zu können, muss die zu korrigierende Störung möglichst genau bekannt sein. Diese Informationen können in einem ersten Fall aus Messungen des Wellenfrontfehlers an Projektionsbelichtungsanlagen während des Betriebes gewonnen werden. Alternativ dazu kann bei im Leitmittel konstanter Bestrahlung auf die absorbierte Lichtmenge und die sich einstellende Temperaturverteilung extrapoliert werden. Daraus können die sich zeitlich entwickelnden Bildfehler berechnet werden und als Grundlage einer Korrektur genutzt werden. Die Extrapolationen können dabei entweder auf zeitgleichen schnellen Simulationsrechnungen beruhen oder ausgehend vorheriger Kalibrierungen beruhend auf einer Messung des Wellenfrontfehlers durchgeführt werden. In jedem Falle sollten bevorzugt dann Messungen in kürzeren Abständen durchgeführt werden, wenn sich die Bestrahlung ändert, z.B. unmittelbar nachdem ein Retikel- oder/und Beleuchtungswechsel stattgefunden hat. Nach solch einem Fall wird die Zeitentwicklung besonders rapide ablaufen, so dass im ersten Fall die Frequenz der Systemmessungen an den zeitlichen Abstand zur letzten Bestrahlungsänderung und die (vorab durch Rechnung oder Messung bekannten) Systemzeitkonstanten angepasst werden kann. Nähert sich das System dem statischen Zustand ("geht es in Sättigung"), muss seltener gemessen werden, entsprechend erhöht sich der Durchsatz an belichteten Wafern der Projektionsbelichtungsanlage.

Eine weitere Problemstellung, die sich aus Sicht des gesamten Projektionsobjektivs stellt, ist der Ort, an dem das erfindungsgemäße optische Element anzuordnen ist. Hierbei ist der Ort im Sinne der optischen Wirkung des erfindungsgemäßen optischen Elementes auf die Wellenfront der optischen Strahlung des Projektionsobjektivs zu verstehen.

Nachfolgend sollen beispielhaft einige bevorzugte Positionen der erfindungsgemäßen optischen Elemente im optischen System erläutert werden. Als Maß für die Position im System dient dabei das so genannte paraxiale Subaperturverhältnis.

Das paraxiale Subaperturverhältnis ist gegeben durch

$$\frac{r}{|h|+|r|}\,\mathrm{sgn}\,h$$

wobei $r$ die paraxiale Randstrahlhöhe, $h$ die paraxiale Hauptstrahlhöhe und die Signumsfunktion $sign\ x$ das Vorzeichen von $x$ bezeichnet, wobei $\mathrm{sgn}\,0=1$ vereinbart sei. Eine Definition des paraxialen Randstrahls bzw. paraxialen Hauptstrahls ist in "Fundamental Optical Design" von Michael J. Kidger, SPIE PRESS, Bellingham, Washington, USA gegeben, welche durch Referenz hierin mit aufgenommen ist.

Das paraxiale Subaperturverhältnis ist eine vorzeichenbehaftete Größe, die ein Maß für die Feld- bzw. Pupillennähe einer Ebene im Strahlengang ist. Per Definition ist das Subaperturverhältnis auf Werte zwischen -1 und 1 normiert, wobei jeder Feldebene eine Nullstelle des paraxialen Subaperturverhältnisses entspricht, und wobei jeder Pupillenebene eine Unstetigkeitsstelle mit einem Sprung des paraxialen Subaperturverhältnisses von -1 nach +1 oder von +1 nach -1 entspricht. Entsprechend bezeichnen paraxiale Subaperturverhältnisse von 0 für die vorliegende Anmeldung Feldebenen, während ein betragsmäßig paraxiales Subaperturverhältnis von 1 eine Pupillenebene bestimmt. Feldnahe Ebenen weisen somit paraxiale Subaperturverhältnisse auf, die nahe bei 0 liegen, während pupillennahe Ebenen paraxiale Subaperturverhältnisse aufweisen, die betragsmäßig nahe bei 1 liegen. Das Vorzeichen des paraxialen Subperturverhältnisses gibt die Stellung der Ebene vor oder hinter einer Bezugsebene an. Zur Definition kann z.B. das Vorzeichen des Durchstoßpunktes eines Komastrahls in der betreffenden Fläche herangezogen werden.

Zwei Ebenen im Strahlengang heißen konjugiert, wenn sie das gleiche paraxiale Subaperturverhältnis haben. Pupillenebenen sind zueinander konjugiert, ebenso Feldebenen.

Die erfindungsgemäßen optischen Elemente bzw. die erfindungsgemäße Anordnung kann dabei in einem Beispiel an einem Ort im System angeordnet sein, an dem das paraxiale Subaperturverhältnis für ein erstes erfindungsgemäßes Element, bzw. für eine erste erfindungsgemäße Anordnung, betragsmäßig größer als 0,8, vorzugsweise größer als 0,9, ist. Zusätzlich oder in einer alternativen Ausführungsform kann ein erfindungsgemäßes optisches Element, bzw. eine erfindungsgemäße Anordnung, vorhanden sein, für das bzw. für die das paraxiale Subaperturverhältnis betragsmäßig kleiner als 0,9, vorzugsweise kleiner als 0,8, ist. Zusätzlich kann ein weiteres erfindungsgemäßes optisches Element, bzw. eine weitere erfindungsgemäße Anordnung, vorhanden sein, deren Subaperturverhältnis betragsmäßig kleiner als 0,8 ist, und deren Subaperturverhältnis das umgekehrte Vorzeichen zu jenem des zweiten Elements, bzw. zu jener der zweiten Anordnung hat.

In einer Ausführungsform sind für zwei erfindungsgemäße optische Elemente, die an verschiedenen Stellen in einem Projektionsobjektiv angeordnet sind, die jeweiligen paraxialen Subaperturverhältnisse um mindestens 0,15, bevorzugt 0,3 von einander verschieden.

In dem dioptrischen Projektionsobjektiv 37 in Figur 201, welches auch in der WO 2003/075096 A2 gezeigt ist, welche hiermit vollumfänglich in diese Anmeldung integriert sei, findet sich ein optisches Element 211, welches als Planplatte ausgelegt ist. Diese Planplatte ist austauschbar ausgelegt. In einer erfindungsgemäßen Ausgestaltung des optischen Elementes 211 ist dieses mit den erfindungsgemäßen Leiterbahnen ausgestattet und kann austauschbar und/oder nicht austauschbar sein. Diese Planplatte befindet sich an einer Stelle, die einem Subaperturverhältnis zwischen 0,9 und 1,0 entspricht. Zur Vermeidung von Streulicht kann das erfindungsgemäße Projektionsobjektiv 37 mit einer Streulichtblende 221 zwischen dem in Richtung des Strahlenganges letztem optischen Element und dem, hier nicht dargestellten, Wafer versehen sein.

In dem katadioptrischen Projektionsobjektiv 37 in Figur 202 findet sich ein optisches Element 212, welches als Planplatte ausgelegt ist. In einer erfindungsgemäßen Ausgestaltung des optischen Elementes 212 ist dieses mit den erfindungsgemäßen Leiterbahnen ausgestattet und kann austauschbar und / oder nicht austauschbar sein. Diese Planplatte befindet sich an einer Stelle, die einem Subaperturverhältnis zwischen -0,8 und -0,9 entspricht. Daher ist diese Planplatte etwas feldnäher als in dem vorherigen Ausführungsbeispiel. Vermeidung von Streulicht kann das erfindungsgemäße Projektionsobjektiv 37 mit einer Streulichtblende 222 in einer Pupillenebene des Projektionsobjektivs 37 versehen sein.

In dem katadioptrischen Projektionsobjektiv 37 in Figur 203, welches auch in der WO 2005/069055 A2 gezeigt ist, welche hiermit vollumfänglich in diese Anmeldung integriert sei, findet sich ein optisches Element 213, welches als Planplatte ausgelegt ist. Diese Planplatte ist austauschbar ausgelegt. In einer erfindungsgemäßen Ausgestaltung des optischen Elementes 213 ist dieses mit den erfindungsgemäßen Leiterbahnen ausgestattet und kann austauschbar und/oder nicht austauschbar sein. Diese Planplatte befindet sich an einer Stelle, die einem Subaperturverhältnis annähernd 1 entspricht, was einer Pupillenebene des Projektionsobjektivs 37 entspricht. Zur Vermeidung von Streulicht kann das erfindungsgemäße Projektionsobjektiv 37 mit einer Streulichtblende 223 in der Nähe eines Zwischenbildes versehen sein. Die Streulichtblende kann dabei das Bild des Scannerschlitzes in der Zwischenbildebene haben.

Ebenso ist die Erfindung in katoptrischen Projektionsobjektiven für die Mikrolithographie einsetzbar.

In den drei obigen Ausführungsbeispielen der Erfindung kann an Stelle eines erfindungsgemäßen optischen Elementes auch eine Mehrzahl solcher an verschiedenen Positionen eingesetzt werden, was die Korrekturmöglichkeiten erhöht.

Bei der Verwendung von zwei oder allgemein mehreren erfindungsgemäßen optischen Elementen tritt als zusätzlich auftretende Problematik der Erfindung die Vermeindung von Moire-Effekten. Die nachfolgenden Ausführungsformen der Erfindung werden für Projektionsobjektive für die Mikrolithograhie formuliert. Sie sind aber auch für andere optische Systeme denkbar.

Eine Möglichkeit, Moire-Effekte zu vermeiden ist, die erfindungsgemäßen optischen Elemente azimutal verschränkt bzgl. der Ausrichtung ihrer Leiterbahnen anzuordnen. Beispielsweise kann man um 90° verschränken. Um die bereits angesprochene, streulichttechnisch vorteilhafte Ausrichtung der Leiterbahnen orthogonal zur Scanrichtung der Projektionsbelichtungsanlage dabei nicht vollständig aufgeben zu müssen, wird, wie in Figur 21 dargestellt, nur eine leichte, insbesondere weniger als 5° betragene, azimutale Verschränkung der Leiterbahnen der jeweiligen erfindungsgemäßen optischen Elemente gegeneinander vorgenommen. Eine solche Verschränkung kann relativ zu mehreren einzelnen erfindungsgemäßen optischen Elementen vorgenommen werden. Sie kann aber auch innerhalb eines einzigen, erfindungsgemäßen optischen Elementes vorgenommen werden.

In Figur 204 ist eine Projektionsbelichtungsanlage 31 für die Halbleiterlithographie, in die die beschriebenen, erfindungsgemäßen optischen Elemente integriert sind, dargestellt. Diese dient zur Belichtung von Strukturen auf ein mit photosensitiven Materialien beschichtetes Substrat, welches im allgemeinen überwiegend aus Silizium besteht und als Wafer 32 bezeichnet wird, zur Herstellung von Halbleiterbauelementen, wie z.B. Computerchips.

Die Projektionsbelichtungsanlage 31 besteht dabei im wesentlichen aus einer Beleuchtungseinrichtung 33, einer Einrichtung 34 zur Aufnahme und exakten Positionierung einer mit einer Struktur versehenen Maske, einem sogenannten Reticle 35, durch welches die späteren Strukturen auf dem Wafer 32 bestimmt werden, einer Einrichtung 36 zur Halterung, Bewegung und exakten Positionierung eben dieses Wafers 32 und einer Abbildungseinrichtung, nämlich einem Projektionsobjektiv 37, mit mehreren optischen Elementen 38, die über Fassungen 39 in einem Objektivgehäuse 40 des Projektionsobjektives 37 gelagert sind. Dabei kann ein erfindungsgemäßes optisches Element 1 an einer beliebigen Stelle im

Projektionsobjektiv 37 oder auch in der Beleuchtungseinrichtung 33 angeordnet

Das grundsätzliche Funktionsprinzip sieht dabei vor, dass die in das Retikel 35 eingebrachten Strukturen auf den Wafer 32 abgebildet werden; die Abbildung wird in der Regel verkleinernd ausgeführt.

Nach einer erfolgten Belichtung wird der Wafer 32 in Pfeilrichtung weiterbewegt, sodass auf demselben Wafer 32 eine Vielzahl von einzelnen Feldern, jeweils mit der durch das Reticle 35 vorgegebenen Struktur, belichtet wird. Der Belichtungsprozess selbst kann dabei während einer relativen Ruheposition von Wafer und Retikel zueinander durchgeführt werden (Wafer- Stepper) oder während einer Relativbewegung von Wafer und Retikel (WaferScanner) .

Die Beleuchtungseinrichtung 33 stellt einen für die Abbildung des Retikels 35 auf dem Wafer 32 benötigten Projektionsstrahl 41, beispielsweise Licht oder eine ähnliche elektromagnetische Strahlung, bereit. Als Quelle für diese Strahlung kann ein Laser oder dergleichen Verwendung finden. Die Strahlung wird in der Beleuchtungseinrichtung 33 über optische Elemente so geformt, dass der Projektionsstrahl 41 beim Auftreffen auf das Retikel 35 die gewünschten Eigenschaften aufweist: Polarisation, homogene Feldausleuchtung ("Uniformität") bzw. Intensitätsprofil, Telezentrie, Abschattung am Feldrand, anwendungsspezifische Pupillenfüllung (Dipol, Quadrupol, annular) mit Anforderungen an Symmetrie.

Über die Strahlen 41 wird ein Bild des Retikels 35 erzeugt und von dem Projektionsobjektiv 37 entsprechend verkleinert auf den Wafer 32 übertragen, wie bereits vorstehend erläutert wurde. Das Projektionsobjektiv 37 weist eine Vielzahl von einzelnen refraktiven, diffraktiven und/oder reflekiven optischen Elementen 38, wie z.B. Linsen, Spiegeln, Prismen, Abschlussplatten und dergleichen auf.

Die vorliegende Erfindung umfasst alle Ausführungsformen, die in den folgenden Sätzen beschrieben sind, die keine Ansprüche, sondern Teil der Beschreibung sind, entsprechend der Entscheidung der juristischen Beschwerdekammer J15/88.

[1] Optisches Element (1) zur zumindest teilweisen, ortsaufgelösten Korrektur eines Wellenfrontfehlers eines mit einer optischen Strahlung beaufschlagbaren optischen Systems, beinhaltend einen für die optische Strahlung optisch wirksamen Bereich und elektrische Leiterbahnen (3) in diesem optisch wirksamen Bereich, wobei die elektrischen Leiterbahnen mindestens abschnittsweise lateral zur Einfallsrichtung der optischen Strahlung einen Durchmesser von höchstens 50 Mikrometer haben.

[2] Optisches Element nach Satz [1], wobei die elektrischen Leiterbahnen lokale Heizzonen ausbilden, die die ortsaufgelöste Korrektur von lateral weniger als 30 Millimetern ermöglichen.

[3] Optisches Element nach Satz [1] oder Satz [2], wobei der Wellenfrontfehler einen Abbildungsfehler beinhaltet, welcher azimutal und/oder radial höherwellig ist.

[4] Optisches Element nach einem der obigen Sätze, wobei das von den Heizzonen erzeugbare Temperaturprofil invers zu dem von der optischen Strahlung im optischen Element erzeugbaren Temperaturprofil ist.

[5] Optisches Element nach einem der obigen Sätze, wobei die elektrischen Leiterbahnen mindestens abschnittsweise lateral zur Einfallsrichtung der optischen Strahlung einen Querschnitt von höchstens 1 oder zwischen 0,5 und 0,01 Mikrometer haben und/oder die Beabstandung der Leiterbahnen zwischen 0.01 und 1, vorzugsweise 0.05 und 0.5, ganz vorzugsweise etwa 0.1 Millimeter beträgt.

[6] Optisches Element nach einem der obigen Sätze, wobei das optische Element eine Linse, Sammellinse, Zerstreuungslinse, Fresnellinse, fresnelsche Zonenplatte, Planplatte, Keilplatte, ein Spiegel oder ein Strahlteiler ist.

[7] Optisches Element nach einem der obigen Sätze, wobei die Wellenlänge der optischen Strahlung in einem Spektralbereich von 0.01 bis 1 Mikrometer liegt.

[8] Optisches Element nach Satz [7], wobei die Wellenlänge der optischen Strahlung etwa 248, 193 oder 13 Nanometer beträgt.

[9] Optisches Element nach einem der obigen Sätze, wobei der optisch wirksame Bereich einen transmittiven Anteil hat, welcher zumindest einen Teil der Leiterbahnen beinhaltet.

[10] Optisches Element nach einem der obigen Sätze, wobei die Leiterbahnen elektrische Anschlusselemente zur Ansteuerung aufweisen.

[11] Optisches Element nach einem der obigen Sätze, wobei der Wellenfrontfehler einen Abbildungsfehler beinhaltet, welcher durch Compaction und/oder Rarefaction eines weiteren optischen Elementes des optischen Systems verursachbar ist.

[12] Optisches Element nach einem der obigen Sätze, wobei sich die Leiterbahnen im Bereich einer Oberfläche des optischen Elementes befinden.

[13] Optisches Element nach einem der obigen Sätze, wobei das optische Element (1) aus einem ersten Substrat (1a) und einem zweiten Substrat (1b) aufgebaut ist und die Leiterbahnen (3) zwischen den beiden Substraten angeordnet sind.

[14] Optisches Element nach Satz [13], wobei das erste Substrat (1a) mit dem zweiten Substrat (1b) mit einer Kittschicht (4) verbunden ist.

[15] Optisches Element nach Satz [13] oder [14], wobei die Leiterbahnen (3) in Ausnehmungen (5) angeordnet sind.

[16] Optisches Element nach Satz [13] bis [15], wobei die Leiterbahnen (3) von einer optischen Schicht (6) bedeckt sind, bei der es sich um eine Antireflexoder hochreflektive Schicht handelt.

[17] Optisches Element nach einem der obigen Sätze, wobei der Querschnitt der Leiterbahnen trapezförmig ist und/oder die Kanten und/oder Ecken der Leiterbahnen verrundet sind.

[18] Optisches Element nach einem der obigen Sätze, wobei eine Verwendelung der Leiterbahnen in einem komplementären Bereich zu dem von der optischen Strahlung beaufschlagbaren Bereich vorliegt.

[19] Optisches Element nach Satz [18], wobei der beaufschlagbare Bereich die Form eines Dipol- oder Quadrupols hat.

[20] Optisches Element nach einem der obigen Sätze, wobei eine Verwendelung der Leiterbahnen in dem von der optischen Strahlung beaufschlagbaren Bereich vorliegt, und das optische Element bei der Wellenlänge der optischen Strahlung ein dem Vorzeichen nach entgegengesetztes dn/dT hat wie ein weiteres, mit optischer Strahlung beaufschlagbares optisches Element des optischen Systems.

[21] Optisches Element nach Satz [20], wobei das optische Element aus Kalziumfluorid, das weitere optische Element aus Quarzglas und die Wellenlänge der optischen Strahlung etwa 193 Nanometer ist.

[22] Optisches Element nach Satz [20], wobei das optische Element aus Quarzglas, das weitere optische Element aus Kalziumfluorid und die Wellenlänge der optischen Strahlung etwa 193 Nanometer ist.

[23] Optisches Element nach einem der obigen Sätze, wobei die Leiterbahnen (3) in einer Draufsicht auf das optische Element (1) in Ausbreitungsrichtung der optischen Strahlung in einer Matrix angeordnet sind.

[24] Optisches Element nach einem der Sätze [1] bis [22], wobei die Leiterbahnen (3) in einer Draufsicht auf das optische Element (1) in Ausbreitungsrichtung der optischen Strahlung radial sternförmig oder rotationssymmetrisch angeordnet sind.

[25] Optisches Element nach Satz [23], wobei die Matrixstruktur äquidistant oder nicht äquidistant ist.

[26] Optisches Element nach einem der obigen Sätze, wobei die Leiterbahnen an in einer Draufsicht auf das optische Element (1) in Blickrichtung der optischen Strahlung gesehenen Kreuzungspunkten mittels Widerständen (8), Dioden, Zener Dioden oder Kombinationen aus diesen verbunden sind.

[27] Optisches Element nach einem der obigen Sätze, wobei die Leiterbahnen durch zumindest eine Widerstandsschicht (9) voneinander getrennt sind.

[28] Optisches Element nach einem der obigen Sätze, wobei die Leiterbahnen durch weitere Leiterbahnen geringeren Querschnittes verbunden sind.

[29] Optisches Element nach einem der obigen Sätze, wobei die Heizzonen (101) individuell ansteuerbar sind.

[30] Optisches Element nach einem der obigen Sätze, wobei die Leiterbahnen jeweils für eine Heizzone (101) gemeinsam über eine Brücke (303) und/oder durch eine gemeinsame Stromschiene elektrisch kontaktiert sind.

[31] Optisches Element nach einem der obigen Sätze, wobei zwischen 100 und 225 Heizzonen (101) existieren.

[32] Optisches Element nach einem der obigen Sätze, wobei die Leiterbahnen mit einer Betriebsspannung von etwa 200 Volt betreibbar sind.

[33] Optisches Element nach einem der obigen Sätze, wobei die Leiterbahnen sich in Zuleitungsdrähte und Heizdrähte unterteilen und die Zuleitungsdrähte einen geringeren spezifischen Widerstand als die Heizdrähte haben und/oder einige der Leiterbahnen, insbesondere genau die Zuleitungsdrähte und/oder genau die Heizdrähte, dotiert sind.

[34] Optisches Element nach einem der obigen Sätze, wobei die Leiterbahnen sich in Zuleitungsdrähte und Heizdrähte unterteilen, welche aus Ag, Cu, Au, Al, Wo, Mo, Sn oder Ni bestehen, bzw. aus Ni, Pt oder Cr oder einem Halbleiter wie Si oder Ge bestehen.

[35] Optisches Element nach einem der obigen Sätze, wobei der Verlauf der Heizdrähte mindestens abschnittsweise durch Radien abgerundet ist.

[36] Optisches Element nach einem der obigen Sätze, wobei die Heizdrähte (302) mäanderformig verteilt liegen und einige der Heizdrähte durch Bypässe (307) verbunden sind.

[37] Optisches Element nach einem der Sätze [10] bis [36], wobei mehr als hundert oder mehr als tausend Anschlusselemente vorliegen, die mittels Wire-Bonding oder flexiblen Leiterfolien (350) an ein Übergabe-Board angeschlossen sind, wobei die Leiterfolien (350) gefaltet und/oder geschlitzt und/oder mit einem elektrisch leitenden Kleber an die Leiterbahnen angebunden sind.

[38] Optisches Element nach einem der obigen Sätze, wobei die Leiterbahnen auf dem optischen Element in ein optisch transparentes Dielektrikum, insbesondere SiO$_2$ eingebettet sind.

[39] Optisches Element nach einem der obigen Sätze, wobei das optische Element aus einem kristallinen Material besteht, insbesondere aus Kalziumfluorid, Bariumfluorid, Barium-Lithiumfluorid, Luthetiumaluminiumgranat oder Spinell.

[40] Optisches Element nach Satz [39], wobei das optische Element zwei Teilelementen enthält, welche relativ zueinander unterschiedliche Kristallorientierungen haben.

[41] Optisches Element nach einem der obigen Sätze, wobei das optische Element als Tauschteil ausgelegt ist.

[42] Optisches Element nach einem der obigen Sätze, wobei das optische System ein Projektionsobjektiv für die Mikrolithographie ist.

[43] Projektionsobjektiv für die Mikrolithographie mit einem optischen Element 1 nach Satz [42].

[44] Projektionsobjektiv nach Satz [43], wobei sich das optische Element in einer Pupillenebene des Projektionsobjektivs befindet.

[45] Projektionsobjektiv nach Satz [43] oder [44], wobei das Projektionsobjektiv dioptrisch, katoptrisch oder katadioptrisch ist.

[46] Projektionsobjektiv nach einen der Sätze [43] bis [45], mit dem eine ortsaufgelöste Korrektur der Wellenfront von 10 bis 15 Prozent eines Pupillendurchmessers des Projektionsobjektivs gewährleistet ist.

[47] Projektionsobjektiv nach einem der Sätze [43] bis [46], wobei das Projektionsobjektiv mit einer nach dem optischen Element nachfolgenden Feldblende (215) ausgestattet ist, die insbesondere die Form eines Bildes des Objektfeldes in einer Zwischenbildebene hat, und/oder mit einer Aperturblende (213) ausgestattet ist, und/oder durch eine Blende (211) nach seiner letzten optisch wirksamen Fläche ausgestattet ist.

[48] Projektionsobjektiv nach einem der Sätze [43] bis [47], wobei das Projektionsobjektiv einen etablierten Manipulator beinhaltet.

[49] Projektionsobjektiv nach einem der Sätze [43] bis [48], wobei das optische Element verlagerbar, insbesondere in Richtung der optischen Strahlung verschiebbar, und/oder verformbar, insbesondere astigmatisch und/oder drei- und/oder vierwellig verformbar ist.

[50] Projektionsobjektiv nach einem der Sätze [43] bis [49], wobei das optische Element an einer Stelle im Projektionsobjektiv angeordnet ist, die einem betragsmässigen Subaperturverhältnis von mehr als 0,8 oder mehr als 0,9 entspricht.

[51] Projektionsobjektiv nach einem der Sätze [43] bis [50], wobei das optische Element an einer Stelle im Projektionsobjektiv angeordnet ist, die einem betragsmässigen Subaperturverhältnis von weniger als 0,9 oder weniger als 0,8 entspricht.

[52] Projektionsobjektiv nach Satz [50], wobei ein zweites optisches Element gemäß einem der Sätze [1] bis [42] an einer Stelle im Projektionsobjektiv angeordnet ist, die einem betragsmässigen Subaperturverhältnis von weniger als 0,8 entspricht und wobei die Vorzeichen der Subaperturverhältnisse des optischen Elementes und des zweiten optischen Elementes verschieden sind.

[53] Projektionsobjektiv nach einem der Sätze [43] bis [52], wobei mehrere optische Elemente gemäß jeweils einem der Sätze [1] bis [42] an Stellen im Projektionsobjektiv angeordnet sind, die betragsmässigen Subaperturverhältnissen entsprechen, die sich um 0,15 oder 0,3 unterscheiden.

[54] Projektionsobjektiv nach einem der Sätze [43] bis [53], wobei das Projektionsobjektiv ein zweites optisches Element nach einem der Sätze [1] bis [42] enthält, und wobei das optische Element und das zweite optische Element bzgl. einer Ausrichtung ihrer jeweiligen Leiterbahnen paarweise um 90° oder um einen Winkel von weniger als 5° azimutal verschränkt voneinander verdreht sind.

[55] Projektionsbelichtungsanlage mit einem Projektionsobjektiv nach einem der Sätze [43] bis [54].

[56] Projektionsbelichtungsanlage nach Satz [55], welche einen Steuerrechner und Wellenfrontsensoren beinhaltet.

[57] Verwendung eines optischen Elementes (1) nach einem der Sätze [1] bis [42], oder eines Projektionsobjektivs nach einem der Sätze [43] bis [54] oder einer Projektionsbelichtungsanlage nach Satz [55] oder [56].

[58] Verfahren zur zumindest teilweisen, ortsaufgelösten Korrektur eines Wellenfrontfehlers eines mit einer optischen Strahlung beaufschlagbaren optischen Systems, beinhaltend ein Ansteuern eines optischen Elementes (1), dieses beinhaltend einen für die optische Strahlung optisch wirksamen Bereich und elektrische Leiterbahnen (3) in diesem optisch wirksamen Bereich, wobei die elektrischen Leiterbahnen mindestens abschnittsweise lateral zur Einfallsrichtung der optischen Strahlung einen Durchmesser von höchstens 50 Mikrometer haben, und wobei die Ansteuerung des optischen Elementes durch eine elektrische Ansteuerung der elektrischen Leiterbahnen vorgenommen wird.

[59] Verfahren nach Satz [58], wobei die Leiterbahnen lokale Heizzonen ausbilden, die eine ortsaufgelöste Korrektur von lateral weniger als 30 Millimetern ermöglichen.

[60] Verfahren nach Satz [58] oder [59], wobei der Wellenfrontfehler und/oder die optische Strahlung zeitlich variabel ist und eine zeitlich variable Ansteuerung des optischen Elementes durch eine zeitlich variable elektrische Ansteuerung der elektrischen Leiterbahnen vorgenommen wird.

[61] Verfahren nach einem der Sätze [58] bis [60], wobei der Wellenfrontfehler einen radial und/oder azimutal höherwelligen Abbildungsfehler enthält.

[62] Verfahren nach einem der Sätze [58] bis [61], wobei die Leiterbahnen (3) gepulst mit Spannung belegt werden.

[63] Verfahren nach einem der Sätze [58] bis [62], wobei Homogenitäts- und/oder Spannungsfehler in weiteren optischen Elementen des optischen Systems korrigiert werden.

[64] Verfahren nach einem der Sätze [58] bis [62], wobei eine parasitäre Heizleistung der Heizzonen durch eine Entkopplungstransformation ansteuerungsseitig entkoppelt wird.

[65] Verfahren nach einem der Sätze [58] bis [64], wobei eine Grobkorrektur mit einem etablierten Manipulator vorgenommen wird.

[66] Verfahren zum Betrieb einer Projektionsbelichtungsanlage für die Mikrolithographie, mit einer Projektionsbelichtungsanlage nach einem der Sätze [55] oder [56].

[67] Verfahren nach Satz [66], wobei die Projektionsbelichtungsanlage eine nach Satz [56] ist und der Steuerrechner Informationen der Wellenfrontsensoren zu der Ansteuerung der elektrischen Leiterbahnen zur Durchführung eines der Verfahren aus einem der Sätze [58] bis [65] verwendet.

[68] Verfahren nach Satz [66] oder [67], wobei das optische Element ausgetauscht wird, insbesondere gegen ein weiteres, unstrukturiertes optisches Element ausgetauscht wird oder ein unstrukturiertes, weiteres optisches Element gegen das optische Element ausgetauscht wird.

[69] Verfahren nach einem der Sätze [66] bis [68], wobei das optische Element verlagert, insbesondere in Richtung der optischen Strahlung verschoben, und/oder verformt, insbesondere astigmatisch und/oder drei- und/oder vierwellig verformt wird.

[70] Verfahren nach einem der Sätze [66] bis [69], wobei eine einzustellende Temperaturverteilung im optischen Element durch Messung und/oder Simulation und/oder Extrapolation einer Temperaturverteilung im Projektionsobjektiv ermittelt wird und eine Berechnung der Korrektur vorgenommen wird.

[71] Verfahren nach einem der Sätze [67] bis [70], wobei die Ansteuerung nach einem Retikel- und/oder Beleuchtungswechsel vorgenommen wird.

[72] Optisches Element (1) mit wenigstens einer optisch wirksamen Fläche mit wenigstens einer im Bereich der wirksamen Fläche verteilt angeordneten elektrischen Leiterbahn (3), wobei die Wechselwirkung der optisch wirksamen Fläche mit der auf die optisch wirksame Fläche einfallenden elektromagnetischen Strahlung durch eine elektrische Ansteuerung der Leiterbahn (3) beeinflussbar ist, dadurch gekennzeichnet,
dass die wenigstens eine Leiterbahn (3) mindestens abschnittsweise orthogonal zur Einfallsrichtung der optischen Strahlung eine Ausdehnung von kleiner als 50 $\mu$m aufweist.

[73] Optisches Element (1) nach Satz [72], dadurch gekennzeichnet, dass das optische Element (1) für die auf die wirksame Fläche fallende Strahlung wenigstens teilweise transparent und/oder teilweise reflektiv ist.

[74] Optisches Element (1) nach einem der Sätze [72] bis [73], dadurch gekennzeichnet, dass das optische Element (1) eine Linse, ein Spiegel oder eine Strahlteilervorrichtung ist.

[75] Optisches Element (1) nach einem der Sätze [72] bis [74], dadurch gekennzeichnet, dass das optische Element eine diffraktive Struktur aufweist.

[76] Optisches Element (1) nach einem der Sätze [72] bis [75], dadurch gekennzeichnet, dass das optische Element (1) zwei miteinander verbundene Substrate (1a, 1b) umfasst, zwischen denen die Leiterbahn (3) angeordnet ist, wobei wenigstens ein Substrat (1a) die optisch wirksame Fläche aufweist.

[77] Optisches Element (1) nach einem der Sätze [72] bis [76], dadurch gekennzeichnet, dass das optische Element (1) wenigstens ein Substrat (1a) mit wenigstens einer Ausnehmung (5) umfasst, wobei die Leiterbahn wenigstens teilweise in der Ausnehmung (5) angeordnet ist.

[78] Optisches Element (1) nach einem der Sätze [72] bis [77], dadurch gekennzeichnet, dass das optische Element (1) eine Oberfläche umfasst und die Leiterbahn (3) wenigstens teilweise auf die Oberfläche aufgebracht ist.

[79] Optisches Element (1) nach einem der Sätze [72] bis [78], dadurch gekennzeichnet, dass die mit der Leiterbahn (3) belegte Oberfläche eine die Leiterbahn (3) wenigstens teilweise bedeckende Schicht (6) umfasst.

[80] Optisches Element (1) nach Satz [79], dadurch gekennzeichnet, dass die Schicht (6) eine reflektierende, hochreflektierende (HR) oder eine Antireflex-(AR)- Schicht ist.

[81] Optisches Element (1) nach einem der Sätze [72] bis [80], dadurch gekennzeichnet, dass der Querschnitt der Leiterbahn (3) senkrecht zu ihrer Längsrichtung etwa ein rechteckiges, trapezförmiges oder rautenförmiges Profil zeigt.

[82] Optisches Element (1) nach Satz [81], dadurch gekennzeichnet, dass das Profil unregelmäßig gestaltete Kanten aufweist.

[83] Optisches Element (1) nach einem der Sätze [72] bis [82], dadurch gekennzeichnet, dass das optische Element eine Leiterbahn (3) umfasst, die entlang ihrer Längsrichtung eine zwei- und/oder dreidimensionale wellenförmige Struktur aufweist.

[84] Optisches Element (1) nach einem der Sätze [72] bis [83], dadurch gekennzeichnet, dass wenigstens zwei Leiterbahnen (3) parallel angeordnet sind.

[85] Optisches Element (1) nach einem der Sätze [72] bis [84], dadurch gekennzeichnet, dass wenigstens zwei Leiterbahnen (3) unter einem von 0° verschiedenen Winkel zueinander angeordnet sind.

[86] Optisches Element (1) nach einem der Sätze [72] bis [85], dadurch gekennzeichnet, dass ein erster Satz von Leiterbahnen (3) unter einem von 0° unterschiedlichen Winkel zu einem zweiten Satz von Leiterbahnen (3) angeordnet ist, wobei sich Leiterbahnen (3) des ersten und zweiten Satzes in Kreuzungspunkten (19) kreuzen.

[87] Optisches Element (1) nach Satz [86], dadurch gekennzeichnet, dass die Kreuzungspunkte (19) miteinander elektrisch verbunden sind.

[88] Optisches Element (1) nach einem der Sätze [86] oder [87], dadurch gekennzeichnet, dass wenigstens ein Satz von Leiterbahnen (3) eine äquidistante Anordnung der Leiterbahnen (3) aufweist.

[89] Optisches Element (1) nach einem der Sätze [86] - [88], dadurch gekennzeichnet, dass wenigstens ein Satz von Leiterbahnen (3) eine nicht äquidistante Anordnung von Leiterbahnen (3) aufweist.

[90] Optisches Element (1) nach einem der Sätze [72] bis [89], dadurch gekennzeichnet, dass mehrere Leiterbahnen (3) sternförmig angeordnet sind.

[91] Optisches Element (1) nach einem der Sätze [72] bis [90], dadurch gekennzeichnet, dass zwischen zwei einzeln ansteuerbaren Leiterbahnen (3) wenigstens ein zusätzlicher Widerstand (8) mit den jeweiligen Leiterbahnen (3) elektrisch verbunden ist.

[92] Optisches Element (1) nach einem der Sätze [72] bis [91], dadurch gekennzeichnet, dass das optische Element wenigstens zwei miteinander verbundene Substrate (1a, 1b) umfasst, und dass zwischen den beiden Substraten (1a, 1b) in wenigstens zwei Ebenen Leiterbahnen (3) angeordnet sind, zwischen denen elektrische Widerstände (8) angeordnet sind.

[93] Optisches Element (1) nach einem der Sätze [72] bis [92], dadurch gekennzeichnet, dass das optische Element (1) wenigstens zwei miteinander verbundene Substrate (1a, 1b) umfasst, und dass in wenigstens einem Substrat (1a) wenigstens teilweise Leiterbahnen (3) angeordnet sind, die mit elektrischen Widerständen (8) verbunden sind.

[94] Optisches Element (1) nach einem der Sätze [72] bis [93], dadurch gekennzeichnet, dass das optische Element (1) an der Oberfläche wenigstens stückweise in zwei übereinander angeordneten Bereichen Leiterbahnen (3) umfasst, wobei zwischen den Bereichen wenigstens ein Widerstand (8) angeordnet ist.

[95] Optisches Element (1) nach einem der Sätze [92] bis [94], dadurch gekennzeichnet, dass zwischen den Ebenen oder Bereichen, in denen die Leiterbahnen (3) angeordnet sind, wenigstens stückweise eine Isolierschicht angeordnet ist.

[96] Optisches Element (1) nach einem der Sätze [72] bis [95], dadurch gekennzeichnet, dass zur Erhöhung des elektrischen Widerstands einer Leiterbahn (3) diese wenigstens stückweise hinsichtlich ihres Querschnitts verengt ausgebildet ist.

[97] Verfahren zur Beeinflussung des optischen Verhaltens eines optischen Elements (1) mit wenigstens einer im Bereich einer optisch wirksamen Fläche angeordneten elektrischen Leiterbahn (3) nach einem der Sätze [72] bis [96] durch elektrische Ansteuerung wenigstens einer Leiterbahn (3) zum lokalen Heizen des optischen Elements (1).

[98] Verfahren nach Satz [97] zur Verbesserung der Abbildungseigenschaften einer Projektionsbelichtungsanlage (31).

[99] Verwendung eines optischen Elements (1) nach einem der Sätze [72] bis [96] zur Beeinflussung des Abbildungsverhaltens eines optischen Abbildungssystems.

[100] Verwendung eines optischen Elements (1) nach einem der Sätze [72] bis [96] in einem optischen Abbildungssystem einer Projektionsbelichtungsanlage (31) für die Halbleiterlithographie.

[101] Projektionsbelichtungsanlage (31) für die Halbleiterlithographie, dadurch gekennzeichnet, dass sie mindestens ein optisches Element (1) nach einem der Sätze [72] bis [96] aufweist.

**Patentansprüche**

1. Optisches Element (1) zur zumindest teilweisen, ortsaufgelösten Korrektur eines Wellenfrontfehlers eines mit einer optischen Strahlung beaufschlagbaren optischen Systems, beinhaltend einen für die optische Strahlung optisch wirksamen Bereich und elektrische Leiterbahnen (3) in diesem optisch wirksamen Bereich, wobei die elektrischen Leiterbahnen mindestens abschnittsweise lateral zur Einfallsrichtung der optischen Strahlung einen Durchmesser von höchstens 50 Mikrometer haben, und wobei das optische Element (1) aus einem ersten Substrat (1a) und einem zweiten Substrat (1b) aufgebaut ist und die Leiterbahnen (3) zwischen den beiden Substraten angeordnet sind.

2. Optisches Element nach Anspruch 1, wobei das erste Substrat (1a) mit dem zweiten Substrat (1b) mit einer Kittschicht (4) verbunden ist.

3. Optisches Element nach Anspruch 1 oder 2, wobei die Leiterbahnen (3) in Ausnehmungen (5) angeordnet sind.

4. Optisches Element nach Anspruch 1 bis 3, wobei die Leiterbahnen (3) von einer optischen Schicht (6) bedeckt sind, bei der es sich um eine Antireflex- oder hochreflektive Schicht handelt.

5. Optisches Element nach einem der obigen Ansprüche 1 - 4, wobei der Querschnitt der Leiterbahnen trapezförmig ist und/oder die Kanten und/oder Ekken der Leiterbahnen verrundet sind.

6. Optisches Element (1) zur zumindest teilweisen, ortsaufgelösten Korrektur eines Wellenfrontfehlers eines mit einer optischen Strahlung beaufschlagbaren optischen Systems, beinhaltend einen für die optische Strahlung optisch wirksamen Bereich und elektrische Leiterbahnen (3) in diesem optisch wirksamen Bereich, wobei die elektrischen Leiterbahnen mindestens abschnittsweise lateral zur Einfallsrichtung der optischen Strahlung einen Durchmesser von höchstens 50 Mikrometer haben, und wobei eine Verwendelung der Leiterbahnen in dem von der optischen Strahlung beaufschlagbaren Bereich vorliegt, und das optische Element bei der Wellenlänge der optischen Strahlung ein dem Vorzeichen nach entgegengesetztes dn/dT hat wie ein weiteres, mit optischer Strahlung beaufschlagbares optisches Element des optischen Systems.

7. Optisches Element nach Anspruch 6, wobei das optische Element aus Kalziumfluorid, das weitere optische Element aus Quarzglas und die Wellenlänge der optischen Strahlung etwa 193 Nanometer ist, oder
das optische Element aus Quarzglas, das weitere optische Element aus Kalziumfluorid und die Wellenlänge der optischen Strahlung etwa 193 Nanometer ist.

8. Optisches Element nach einem der obigen Ansprüche 6 oder 7, wobei die Leiterbahnen (3) in einer Draufsicht auf das optische Element (1) in Ausbreitungsrichtung der optischen Strahlung in einer Matrix angeordnet sind.

9. Optisches Element nach einem der Ansprüche 6 - 8, wobei die Leiterbahnen (3) in einer Draufsicht auf das optische Element (1) in Ausbreitungsrichtung der optischen Strahlung radial sternförmig oder rotationssymmetrisch angeordnet sind.

10. Optisches Element nach einem der obigen Ansprüche 6 - 9, wobei die Leiterbahnen an in einer Draufsicht auf das optische Element (1) in Blickrichtung der optischen Strahlung gesehenen Kreuzungspunkten mittels Widerständen (8), Dioden, Zener Dioden oder Kombinationen aus diesen verbunden sind.

11. Optisches Element nach einem der obigen Ansprüche 6 - 10, wobei die Leiterbahnen durch zumindest eine Widerstandsschicht (9) voneinander getrennt sind.

12. Optisches Element nach einem der obigen Ansprüche 6 - 11, wobei die Leiterbahnen durch weitere Leiterbahnen geringeren Querschnittes verbunden sind.

13. Optisches Element nach einem der obigen Ansprüche 6 - 12, wobei Heizzonen (101) individuell ansteuerbar sind.

14. Optisches Element nach Anspruch 13, wobei die Leiterbahnen jeweils für eine Heizzone (101) gemeinsam über eine Brücke (303) und/oder durch eine gemeinsame Stromschiene elektrisch kontaktiert sind.

15. Optisches Element nach einem der obigen Ansprüche 13 oder 14, wobei zwischen 100 und 225 Heizzonen (101) existieren.

16. Optisches Element nach einem der obigen Ansprüche 6 - 15, wobei die Leiterbahnen mit einer Betriebsspannung von etwa 200 Volt betreibbar sind.

17. Optisches Element (1) zur zumindest teilweisen, ortsaufgelösten Korrektur eines Wellenfrontfehlers eines mit einer optischen Strahlung beaufschlagbaren optischen Systems, beinhaltend einen für die optische Strahlung optisch wirksamen Bereich und elektrische Leiterbahnen (3) in diesem optisch wirksamen Bereich, wobei die elektrischen Leiterbahnen mindestens abschnittsweise lateral zur Einfallsrichtung der optischen Strahlung einen Durchmesser von höchstens 50 Mikrometer haben, und wobei die Leiterbahnen sich in Zuleitungsdrähte und Heizdrähte unterteilen und die Zuleitungsdrähte einen geringeren spezifischen Widerstand als die Heizdrähte haben und / oder einige der Leiterbahnen, insbesondere genau die Zuleitungsdrähte und/oder genau die Heizdrähte, dotiert sind.

18. Optisches Element nach Anspruch 17, wobei die Leiterbahnen sich in Zuleitungsdrähte und Heizdrähte unterteilen, welche aus Ag, Cu, Au, Al, Wo, Mo, Sn oder Ni bestehen, bzw. aus Ni, Pt oder Cr oder einem Halbleiter wie Si oder Ge bestehen.

19. Optisches Element nach einem der obigen Ansprüche 17 oder 18, wobei die Heizdrähte (302) mäanderförmig verteilt liegen und einige der Heizdrähte durch Bypässe (307) verbunden sind.

20. Optisches Element nach einem der Ansprüche 17 - 19, wobei mehr als hundert oder mehr als tausend Anschlusselemente vorliegen, die mittels Wire-Bonding oder flexiblen Leiterfolien (350) an ein Übergabe-Board angeschlossen sind, wobei die Leiterfolien (350) gefaltet und/oder geschlitzt und/oder mit einem elektrisch leitenden Kleber an die Leiterbahnen angebunden sind.

21. Optisches Element nach einem der obigen Ansprüche 17 - 20, wobei die Leiterbahnen auf dem optischen Element in ein optisch transparentes Dielektrikum, insbesondere $SiO_2$ eingebettet sind.

22. Optisches Element nach einem der obigen Ansprüche 17 - 21, wobei das optische Element aus einem kristallinen Material besteht, insbesondere aus Kalziumfluorid, Bariumfluorid, Barium-Lithiumfluorid, Luthetiumaluminiumgranat oder Spinell.

23. Optisches Element nach Anspruch 22, wobei das optische Element zwei Teilelemente enthält, welche relativ zueinander unterschiedliche Kristallorientierungen haben.

24. Projektionsobjektiv für die Mikrolithographie mit einem optischen Element nach einem der obigen Ansprüche.

25. Projektionsobjektiv nach Anspruch 24, wobei sich das optische Element in einer Pupillenebene des Projektionsobjektivs befindet und/oder wobei das Projektionsobjektiv dioptrisch, katoptrisch oder katadioptrisch ist, und/oder wobei das Projektionsobjektiv mit einer nach dem optischen Element nachfolgenden Feldblende (215) ausgestattet ist, die insbesondere die Form eines Bildes des Objektfeldes in einer Zwischenbildebene hat, und/oder mit einer Aperturblende (213) ausgestattet ist, und/oder durch eine Blende (211) nach seiner letzten optisch wirksamen Fläche ausgestattet ist, und/oder wobei das optische Element verlagerbar, insbesondere in Richtung der optischen Strahlung verschiebbar, und/oder verformbar, insbesondere astigmatisch und/oder drei- und/oder vierwellig verformbar ist, und/oder wobei das optische Element an einer Stelle im Projektionsobjektiv angeordnet ist, die einem betragsmässigen Subaperturverhältnis von mehr als 0,8 oder mehr als 0,9 entspricht.

26. Projektionsobjektiv für die Mikrolithographie mit einem optischen Element, wobei das optische Element zwei optische Elemente enthält, wobei die optischen Elemente einen für die optische Strahlung optisch wirksamen Bereich und elektrische Leiterbahnen (3) in diesem optisch wirksamen Bereich enthalten, wobei die elektrischen Leiterbahnen mindestens abschnittsweise lateral zur Einfallsrichtung der optischen Strahlung einen Durchmesser von höchstens 50 Mikrometer haben, und wobei das optische Element und das zweite optische Element bzgl. einer Ausrichtung ihrer jeweiligen Leiterbahnen paarweise um 90° oder um einen Winkel von weniger als 5° azimutal verschränkt voneinander verdreht sind.

27. Projektionsobjektiv nach Anspruch 26, wobei auf mindestens einem optischen Element Heizzonen (101) angeordnet sind, welche individuell ansteuerbar sind.

28. Projektionsobjektiv nach Anspruch 26 oder 27, wobei die Leiterbahnen sich in Zuleitungsdrähte und Heizdrähte unterteilen und die Zuleitungsdrähte einen geringeren spezifischen Widerstand als die Heizdrähte haben und / oder einige der Leiterbahnen, insbesondere genau die Zuleitungsdrähte und / oder genau die Heizdrähte, dotiert sind.

29. Projektionsbelichtungsanlage mit einem Projektionsobjektiv nach einem der Ansprüche 26 - 28.

30. Projektionsbelichtungsanlage nach Anspruch 29, welche einen Steuerrechner und Wellenfrontsensoren beinhaltet.

## FIG.100

## FIG.101

$$\Delta \varphi' \approx \Delta n \frac{d\varphi}{dT} \Delta T$$

$$\Delta \varphi \approx \Delta Z \frac{d\varphi}{dT} \Delta T$$

3

Fig. 1

Fig. 2

Fig. 3

Fig. 4a    Fig. 4b    Fig. 4c    Fig. 4d

Fig. 5a

Fig. 5b

Fig. 6

Fig. 7

Fig. 8

Fig. 9a

Fig. 9b

Fig. 10

Fig. 11

Fig. 12

Fig. 13

Fig. 14

Fig. 15

Fig. 16

302

306

301

Fig. 17

302

307

301

Fig. 18

301

303

Fig. 19

301

350    351    Fig. 20

35

Fig. 21

Fig. 201

Fig. 202

213

223

37

Fig. 203

Fig. 204

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19824030 A1
- EP 678768 A
- DE 19859634 A1
- US 6198579 B1
- DE 19827602 A1
- WO 2004036316 A
- US 6081388 A
- US 6521877 B1
- US 6466382 B2

- US 20070019305 A1
- US 20030021040 A1
- WO 2006128613 A1
- JP 2004246343 A
- EP 0678768 A2
- DE 102005062401 A1
- WO 2003075096 A2
- WO 2005069055 A2

**In der Beschreibung aufgeführte Nicht-Patentliteratur**

- **MICHAEL J. KIDGER.** Fundamental Optical Design. SPIE PRESS